(19) **Europäisches Patentamt / European Patent Office / Office européen des brevets**

(11) **EP 4 672 753 A1**

(12) **EUROPEAN PATENT APPLICATION**
published in accordance with Art. 153(4) EPC

(43) Date of publication:
**31.12.2025 Bulletin 2026/01**

(21) Application number: **23933383.4**

(22) Date of filing: **18.04.2023**

(51) International Patent Classification (IPC):
**H04N 19/597** (2014.01)

(52) Cooperative Patent Classification (CPC):
**H04N 19/597**

(86) International application number:
**PCT/CN2023/089028**

(87) International publication number:
**WO 2024/216504 (24.10.2024 Gazette 2024/43)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **HUAWEI TECHNOLOGIES CO., LTD.**
**Shenzhen, Guangdong 518129 (CN)**

(72) Inventors:
• **TANG, Zihan**
  **Shenzhen, Guangdong 518129 (CN)**
• **MA, Mengyao**
  **Shenzhen, Guangdong 518129 (CN)**
• **LUO, Jiajin**
  **Shenzhen, Guangdong 518129 (CN)**
• **YAN, Min**
  **Shenzhen, Guangdong 518129 (CN)**

(74) Representative: **Pfenning, Meinig & Partner mbB**
**Patent- und Rechtsanwälte**
**Theresienhöhe 11a**
**80339 München (DE)**

(54) **DATA COMPRESSION METHOD, DATA DECOMPRESSION METHOD AND RELATED DEVICE**

(57) This application discloses a data compression method, a data decompression method, and a related apparatus. The method includes: matching an element in a first group of data with an element in a second group of data, to obtain a first matching relationship; performing differencing on matched elements in the first group of data and the second group of data based on the first matching relationship, to obtain first differential data; separately performing uniform quantization on data in each dimension in the first differential data, to obtain a first quantization result; performing entropy encoding compression based on the first quantization result, to obtain compressed data; and sending the compressed data to a receiver. Therefore, a time correlation characteristic of data can be effectively used, to reduce an amount of data that needs to be compressed. Uniform quantization is separately performed on data in each dimension in the first differential data, to obtain the first quantization result, so that decompressed data can meet an absolute accuracy requirement.

FIG. 6

## Description

## TECHNICAL FIELD

This application relates to the field of data compression, and in particular, to a data compression method, a data decompression method, and a related apparatus.

## BACKGROUND

Existing compression technologies for multi-dimensional data are mainly classified into two types, one is vector quantization (vector quantization, VQ), and the other is transform domain compression, for example, a compression method based on linear transform such as discrete cosine transform (discrete cosine transform, DCT) or discrete wavelet transform (discrete wavelet transform, DWT), and a nonlinear transform domain compression method based on deep learning tools such as a variational auto-encoder (variational auto-encoder, VAE) and a stream model. VQ is an effective lossy compression technology developed in late 1970s, and a theoretical basis of VQ is Shannon's rate distortion theory. A basic principle of vector quantization is to replace an input vector with an index of a codeword that is most matched with the input vector in a codebook for transmission and storage, and only a simple table lookup operation is required during decoding. Outstanding advantages of vector quantization are a high compression ratio, simple decoding, and a capability to well retain details of a signal. Details of the foregoing methods are not described herein. However, it should be noted that each of the foregoing compression methods does not enable each decompressed element to meet a given accuracy requirement, that is, does not enable an error between a value obtained through data decompression and an original value to be strictly less than a given upper bound. Therefore, it is necessary to study a compression technology that enables each decompressed element to meet the given accuracy requirement.

## SUMMARY

Embodiments of this application disclose a data compression method, a data decompression method, and a related apparatus, to enable each decompressed element to meet a given accuracy requirement.

According to a first aspect, an embodiment of this application provides a data compression method. The method includes: matching an element in a first group of data with an element in a second group of data, to obtain a first matching relationship, where the first group of data is data to be received by a receiver, and the second group of data is data that has been successfully received by the receiver; performing differencing on matched elements in the first group of data and the second group of data based on the first matching relationship, to obtain first differential data; separately performing uniform quantization on data in each dimension in the first differential data, to obtain a first quantization result; performing entropy encoding compression based on the first quantization result, to obtain compressed data; and sending the compressed data to the receiver.

In this embodiment of this application, differencing is performed on the matched elements in the first group of data and the second group of data, to obtain the first differential data. Therefore, a time correlation characteristic of data can be effectively used, to reduce a compressed data amount, that is, an amount of compressed data. Uniform quantization is separately performed on the data in each dimension in the first differential data, to obtain the first quantization result. Therefore, an error between each element of decompressed data at the receiver and a real value meets a given accuracy requirement.

In a possible implementation, the performing entropy encoding compression based on the first quantization result, to obtain the compressed data includes: transforming the first quantization result into a nonnegative integer, to obtain a first transformation result; and performing entropy encoding compression on the first transformation result, to obtain the compressed data.

In a possible implementation, the separately performing uniform quantization on the data in each dimension in the first differential data, to obtain the first quantization result includes: separately performing uniform quantization on the data in each dimension in the first differential data based on preset error accuracy, to obtain the first quantization result.

In this implementation, uniform quantization is separately performed on the data in each dimension in the first differential data based on the preset error accuracy. Therefore, each element of the decompressed data at the receiver can meet an absolute accuracy requirement.

In a possible implementation, the matching the element in the first group of data with the element in the second group of data includes: performing differencing on the matched elements in the first group of data and the second group of data based on the first matching relationship, to obtain the first differential data, where the first matching relationship is an assumed matching relationship between an element in the first group of data and an element in the second group of data; separately performing uniform quantization on the data in each dimension in the first differential data, to obtain the first quantization result; determining a first code length of a codeword obtained by performing entropy encoding compression based on the first quantization result; performing differencing on matched elements in the first group of data and the second group of data based on a second matching relationship, to obtain second differential data, where the second matching relationship is an assumed matching relationship between an element in the first group of data and an element in the second group of data, and the second matching relationship is different from the first matching relationship; separately performing uniform quantization on data in each dimension in the second differential data, to obtain a second quantization result; determining a second code length of a codeword obtained by performing entropy encoding compression based on the second quantization result; and when the first code length is a shortest code length in multiple code lengths obtained by performing entropy encoding compression on the first group of data, using the first matching relationship as a matching relationship between an element in the first group of data and an element in the second group of data, where the multiple code lengths include the first code length and the second code length. An example of this implementation is as follows: The first group of data is actually compressed once based on all possible matching relationships (or pairing relationships) between an element in the first group of data and an element in the second group of data, and the first matching relationship of the codeword with the shortest code length obtained through actual compression is selected. In this application, matching and pairing have a same meaning. A shortest code length in the multiple code lengths may be referred to as a first shortest code length, a shortest code length in the multiple code lengths other than the first shortest code length may be referred to as a second shortest code length, a shortest code length in the multiple code lengths other than the first shortest code length and the second shortest code length may be referred to as a third shortest code length, and so on. When the first code length is the shortest code length in the multiple code lengths obtained by performing entropy encoding compression on the first group of data, using the first matching relationship as the matching relationship between the element in the first group of data and the element in the second group of data may be replaced with: when the first code length is an $S^{th}$ shortest code length in the multiple code lengths obtained by performing entropy encoding compression on the first group of data, using the first matching relationship as the matching relationship between the element in the first group of data and the element in the second group of data, where S is an integer greater than 0. For example, S is 1, 2, 3, 4, or 5, and S may be less than a preset value, for example, 6, 8, or 10.

In this implementation, when the first code length is the shortest code length in the multiple code lengths obtained by performing entropy encoding compression on the first group of data, the first matching relationship is used as the matching relationship between the element in the first group of data and the element in the second group of data. Therefore, a compression effect can be improved.

In a possible implementation, the matching the element in the first group of data with the element in the second group of data includes: performing differencing on the matched elements in the first group of data and the second group of data based on the first matching relationship, to obtain the first differential data, where the first matching relationship is an assumed matching relationship between an element in the first group of data and an element in the second group of data; separately performing uniform quantization on the data in each dimension in the first differential data, to obtain the first quantization result; separately transforming data in each dimension in the first quantization result into a nonnegative integer, to obtain a first transformation result; determining a first code length of a codeword obtained by performing entropy encoding compression based on a first group of entropy encoding parameters and the first transformation result; performing differencing on matched elements in the first group of data and the second group of data based on a second matching relationship, to obtain second differential data, where the second matching relationship is an assumed matching relationship between an element in the first group of data and an element in the second group of data, and the second matching relationship is different from the first matching relationship; separately performing uniform quantization on data in each dimension in the second differential data, to obtain a second quantization result; separately transforming data in each dimension in the second quantization result into a nonnegative integer, to obtain a second transformation result; determining a second code length of a codeword obtained by performing entropy encoding compression based on a second group of entropy encoding parameters and the second transformation result, where the second group of entropy encoding parameters is the same as or different from the first group of entropy encoding parameters; and when the first code length is a shortest code length in multiple code lengths obtained by performing entropy encoding compression on the first group of data, using the first matching relationship as a matching relationship between an element in the first group of data and an element in the second group of data, where the multiple code lengths include the first code length and the second code length; and the performing entropy encoding compression based on the first quantization result, to obtain the compressed data includes: separately transforming the data in each dimension in the first quantization result into the nonnegative integer, to obtain the first transformation result; and separately performing entropy encoding compression on data in a corresponding dimension in the first transformation result by using an entropy encoding parameter in each dimension in the first group of entropy encoding parameters, to obtain the compressed data, where the compressed data includes first indication information, and the first indication information indicates the first group of entropy encoding parameters. A main principle of this implementation is: jointly optimizing the matching relationship and the entropy encoding parameter, to perform entropy encoding compression on the first group of data by using the jointly optimized matching relationship and entropy encoding parameter.

In this implementation, when the first code length is the shortest code length in the multiple code lengths obtained by performing entropy encoding compression on the first group of data, the first matching relationship is used as the matching relationship between the element in the first group of data and the element in the second group of data. Therefore, the matching relationship and the entropy encoding parameter that have better compression performance can be obtained, to improve compression performance.

In a possible implementation, when a quantity of elements in the first group of data is less than a quantity of elements in the second group of data, the compressed data includes a first bitmap, one bit in the first bitmap corresponds to one element in the second group of data, and the first bitmap indicates whether an element in the second group of data is matched with an element in the first group of data.

In this implementation, the compressed data includes the first bitmap, so that the receiver determines the matching relationship between the element in the second group of data and the element in the first group of data based on the first bitmap.

In a possible implementation, an arrangement order of elements corresponding to bits in the first bitmap is the same as a compression encoding or decoding order of elements in the second group of data.

In this implementation, the receiver can perform decoding more quickly.

In a possible implementation, the compressed data further includes second indication information, the second indication information indicates a quantity of third data groups, and the second group of data is obtained by combining two or more third data groups.

In this implementation, the compressed data further includes the second indication information, so that the receiver can determine the quantity of third data groups.

In a possible implementation, an order of elements in the compressed data corresponds to a decoding order of elements in the second group of data at the receiver. In this application, the decoding order of elements in the second group of data at the receiver is equivalent to a decompression order of elements in the second group of data at the receiver.

In this implementation, the receiver can perform decoding more quickly, and a decoding workload is reduced.

In a possible implementation, after the matching the element in the first group of data with the element in the second group of data, to obtain the first matching relationship, the method further includes: when the quantity of elements in the first group of data is greater than the quantity of elements in the second group of data, matching a first part of elements with a second part of elements in the first group of data, to obtain a third matching relationship, where the first part of elements are an element that is in the first group of data and that is not matched with an element in the second group of data, and the second part of elements are an element that is in the first group of data and that is matched with an element in the second group of data; performing differencing on matched elements in the first part of elements and the second part of elements based on the third matching relationship, to obtain third differential data; and separately performing uniform quantization on data in each dimension in the third differential data, to obtain a third quantization result; and the performing entropy encoding compression based on the first quantization result, to obtain the compressed data includes: performing entropy encoding compression based on the first quantization result and the third quantization result, to obtain the compressed data, where the compressed data includes a second bitmap, one bit in the second bitmap corresponds to one element in the second part of elements, and the second bitmap indicates whether an element in the second part of elements is matched with an element in the first part of elements.

In this implementation, when the quantity of elements in the first group of data is greater than the quantity of elements in the second group of data, the first part of elements is matched with the second part of elements in the first group of data. When the quantity of elements in the first group of data is greater than the quantity of elements in the second group of data, data compression may also be performed in a manner of differential and then compression.

In a possible implementation, an arrangement order of elements corresponding to bits in the second bitmap is the same as a compression encoding or decoding order of elements in the second part of elements.

In this implementation, the arrangement order of the elements corresponding to the bits in the second bitmap is the same as the compression encoding or decoding order of elements in the second part of elements, so that the receiver can determine the elements corresponding to the bits in the second bitmap.

In a possible implementation, the compressed data includes first compressed sub-data and second compressed sub-data, the first compressed sub-data corresponds to the first differential data, the second compressed sub-data corresponds to the third differential data, an order of elements in the first compressed sub-data corresponds to a decoding order of elements in the second group of data at the receiver, an order of elements in the second compressed sub-data corresponds to a decoding order of elements in a third part of elements at the receiver, and the third part of elements are an element that is in the second part of elements and that is matched with an element in the first part of elements.

In a possible implementation, the compressed data further includes third indication information, and the third indication information indicates whether the compressed data is obtained in a differential manner.

In a possible implementation, the compressed data further includes fourth indication information, and the fourth indication information indicates whether a transmitter successfully decodes acknowledgment ACK (Acknowledgment) signaling that is most recently fed back by the receiver for data from the transmitter. The ACK signaling indicates that the receiver successfully receives the data from the transmitter.

In this implementation, the compressed data further includes the fourth indication information, to determine data referenced by the compressed data sent by the transmitter.

In a possible implementation, the first group of data is ray tracking (ray tracing) data, multi-target positioning data, or channel state information (channel state information, CSI) data. The first group of data is air interface time-related data having time correlation, for example, the ray tracing data, the multi-target positioning data, or the CSI data.

According to a second aspect, an embodiment of this application provides a data decompression method. The method includes: receiving compressed data from a transmitter; decoding the compressed data, to obtain first differential data; and adding each element in the first differential data and a reference element corresponding to each element, to obtain a first group of data, where each element in the first differential data corresponds to one element in a second group of data, a reference element of a first element in the first differential data is an element corresponding to the first element in the second group of data, the second group of data is data that has been successfully received by a receiver, and the first element is any element in the first differential data.

In this embodiment of this application, each element in the first differential data is added to the reference element corresponding to each element, to obtain the first group of data. Therefore, an error between each element of decompressed data at the receiver and a real value meets a given accuracy requirement.

In a possible implementation, the compressed data includes first indication information, and the first indication information indicates a first group of entropy encoding parameters; and the decoding the compressed data, to obtain the first differential data includes: determining the first group of entropy encoding parameters based on the first indication information; and separately decoding data in a corresponding dimension in the compressed data by using an entropy encoding parameter in each dimension in the first group of entropy encoding parameters, to obtain the first differential data.

In this implementation, the data in the corresponding dimension in the compressed data is separately decoded by using the entropy encoding parameter in each dimension in the first group of entropy encoding parameters. Therefore, each element of the decompressed data at the receiver can meet an absolute accuracy requirement.

In a possible implementation, the compressed data includes a first bitmap, one bit in the first bitmap corresponds to one element in the second group of data, and the first bitmap indicates whether an element in the second group of data is matched with an element in the first group of data; and the method further includes: determining, based on the first bitmap, the reference element corresponding to each element in the first differential data.

In this implementation, the first bitmap indicates whether the element in the second group of data is matched with the element in the first group of data, and the receiver may determine a matching relationship between the element in the second group of data and the element in the first group of data based on the first bitmap.

In a possible implementation, an arrangement order of elements corresponding to bits in the first bitmap is the same as a compression encoding or decoding order of elements in the second group of data.

In this implementation, the receiver can perform decoding more quickly, and signaling overheads are reduced.

In a possible implementation, the compressed data further includes second indication information, the second indication information indicates a quantity of third data groups, and the second group of data is obtained by combining two or more third data groups.

In this implementation, the compressed data further includes the second indication information, so that the receiver can determine the quantity of third data groups.

In a possible implementation, an order of elements in the compressed data corresponds to a decoding order of elements in the second group of data at the receiver.

In this implementation, the receiver can perform decoding more quickly, and a decoding workload can be reduced.

In a possible implementation, the decoding the compressed data, to obtain the first differential data includes: decoding the compressed data, to obtain the first differential data and third differential data, where the compressed data includes a second bitmap, one bit in the second bitmap corresponds to one element in the first differential data, and the second bitmap indicates whether an element in the first differential data is matched with an element in the third differential data; and the adding each element in the first differential data and the reference element corresponding to each element, to obtain the first group of data includes: adding each element in the first differential data and the reference element corresponding to each element, and adding each element in the third differential data and a reference element corresponding to each element, to obtain the first group of data, where a reference element corresponding to a second element in the third differential data is a sum of a third element corresponding to the second element in the first differential data and a reference element corresponding to the third element, and the second element is any element in the third differential data.

In this implementation, each element in the third differential data is added to the reference element corresponding to each element, to obtain, through decoding, the first group of data that includes elements more than elements in the second group of data that is used as reference data.

In a possible implementation, an arrangement order of elements corresponding to bits in the second bitmap is the same as a compression encoding or decoding order of elements in the first differential data.

In this implementation, the receiver can perform decoding more quickly, and a decoding workload can be reduced.

In a possible implementation, an order of elements in the first differential data corresponds to a decoding order of elements in the second group of data at the receiver, and an order of elements in the third differential data corresponds to a decoding order, at the receiver, of elements that are in the first differential data and that are associated with the third differential data.

In this implementation, the receiver can perform decoding more quickly, and a decoding workload can be reduced.

In a possible implementation, the compressed data further includes third indication information, and the third indication information indicates whether the compressed data is obtained in a differential manner.

In a possible implementation, the compressed data further includes fourth indication information, and the fourth indication information indicates whether a transmitter successfully decodes acknowledgment ACK signaling that is most recently fed back by the receiver for data from the transmitter.

In this implementation, the compressed data further includes the fourth indication information, and the receiver may determine data referenced by the compressed data sent by the transmitter.

In a possible implementation, the first group of data is ray tracing (ray tracing) data, multi-target positioning data, or CSI data. The first group of data is air interface time-related data having time correlation, for example, the ray tracing data, the multi-target positioning data, or the CSI data.

According to a third aspect, an embodiment of this application provides a communication apparatus. The communication apparatus has a function of implementing behavior in the method embodiment in the first aspect. The communication apparatus may be a communication device, may be a component (for example, a processor, a chip, or a chip system) of the communication device, or may be a logical module or software that can implement all or some functions of the communication device. The function of the communication apparatus may be implemented by hardware, or may be implemented by hardware executing corresponding software. The hardware or the software includes one or more modules or units corresponding to the foregoing function. In a possible implementation, the communication apparatus includes a transceiver unit and a processing unit. The processing unit is configured to match an element in a first group of data with an element in a second group of data, to obtain a first matching relationship, where the first group of data is data to be received by a receiver, and the second group of data is data that has been successfully received by the receiver; performing differencing on matched elements in the first group of data and the second group of data based on the first matching relationship, to obtain first differential data; separately performing uniform quantization on data in each dimension in the first differential data, to obtain a first quantization result; performing entropy encoding compression based on the first quantization result, to obtain compressed data. The transceiver unit is configured to send the compressed data to the receiver.

In a possible implementation, the processing unit is specifically configured to transform the first quantization result into a nonnegative integer, to obtain a first transformation result; and perform entropy encoding compression on the first transformation result, to obtain the compressed data.

In a possible implementation, the processing unit is specifically configured to separately perform uniform quantization on the data in each dimension in the first differential data based on preset error accuracy, to obtain the first quantization result.

In a possible implementation, the processing unit is specifically configured to perform differencing on the matched elements in the first group of data and the second group of data based on the first matching relationship, to obtain the first differential data, where the first matching relationship is an assumed matching relationship between an element in the first group of data and an element in the second group of data; separately perform uniform quantization on the data in each dimension in the first differential data, to obtain the first quantization result; determine a first code length of a codeword obtained by performing entropy encoding compression based on the first quantization result; perform differencing on matched elements in the first group of data and the second group of data based on a second matching relationship, to obtain second differential data, where the second matching relationship is an assumed matching relationship between an element in the first group of data and an element in the second group of data, and the second matching relationship is different from the first matching relationship; separately perform uniform quantization on data in each dimension in the second differential data, to obtain a second quantization result; determine a second code length of a codeword obtained by performing entropy encoding compression based on the second quantization result; and when the first code length is a shortest code length in multiple code lengths obtained by performing entropy encoding compression on the first group of data, use the first matching relationship as a matching relationship between an element in the first group of data and an element in the second group of data, where the multiple code lengths include the first code length and the second code length. An example of this implementation is as follows: The first group of data is actually compressed once based on all possible matching relationships (or pairing relationships) between an element in the first group of data and an element in the second group of data, and the first matching relationship of the codeword with the shortest code length obtained through actual compression is selected.

In a possible implementation, the processing unit is specifically configured to perform differencing on the matched elements in the first group of data and the second group of data based on the first matching relationship, to obtain the first differential data, where the first matching relationship is an assumed matching relationship between an element in the first group of data and an element in the second group of data; separately perform uniform quantization on the data in each dimension in the first differential data, to obtain the first quantization result; separately transform data in each dimension in the first quantization result into a nonnegative integer, to obtain a first transformation result; determine a first code length of a codeword obtained by performing entropy encoding compression based on a first group of entropy encoding parameters and the first transformation result; perform differencing on matched elements in the first group of data and the second group of data based on a second matching relationship, to obtain second differential data, where the second matching relationship is an assumed matching relationship between an element in the first group of data and an element in the second group of data, and the second matching relationship is different from the first matching relationship; separately perform uniform quantization on data in each dimension in the second differential data, to obtain a second quantization result; separately transform data in each dimension in the second quantization result into a nonnegative integer, to obtain a second transformation result; determine a second code length of a codeword obtained by performing entropy encoding compression based on a second group of entropy encoding parameters and the second transformation result, where the second group of entropy encoding parameters is the same as or different from the first group of entropy encoding parameters; and when the first code length is a shortest code length in multiple code lengths obtained by performing entropy encoding compression on the first group of data, use the first matching relationship as a matching relationship between an element in the first group of data and an element in the second group of data, where the multiple code lengths include the first code length and the second code length; and the performing entropy encoding compression based on the first quantization result, to obtain the compressed data includes: separately transforming the data in each dimension in the first quantization result into the nonnegative integer, to obtain the first transformation result; and separately performing entropy encoding compression on data in a corresponding dimension in the first transformation result by using an entropy encoding parameter in each dimension in the first group of entropy encoding parameters, to obtain the compressed data, where the compressed data includes first indication information, and the first indication information indicates the first group of entropy encoding parameters.

In a possible implementation, the processing unit is specifically configured to: when a quantity of elements in the first group of data is less than a quantity of elements in the second group of data, the compressed data includes a first bitmap, one bit in the first bitmap corresponds to one element in the second group of data, and the first bitmap indicates whether an element in the second group of data is matched with an element in the first group of data.

In a possible implementation, the processing unit is specifically configured to: an arrangement order of elements corresponding to bits in the first bitmap is the same as a compression encoding or decoding order of elements in the second group of data.

In a possible implementation, the processing unit is specifically configured to: the compressed data further includes second indication information, the second indication information indicates a quantity of third data groups, and the second group of data is obtained by combining two or more third data groups.

In a possible implementation, the processing unit is specifically configured to: an order of elements in the compressed data corresponds to a decoding order of elements in the second group of data at the receiver.

In a possible implementation, the processing unit is further configured to: when the quantity of elements in the first group of data is greater than the quantity of elements in the second group of data, match a first part of elements with a second part of elements in the first group of data, to obtain a third matching relationship, where the first part of elements are an element that is in the first group of data and that is not matched with an element in the second group of data, and the second part of elements are an element that is in the first group of data and that is matched with an element in the second group of data; perform differencing on matched elements in the first part of elements and the second part of elements based on the third matching relationship, to obtain third differential data; and separately perform uniform quantization on data in each dimension in the third differential data, to obtain a third quantization result; and the processing unit is specifically configured to perform entropy encoding compression based on the first quantization result and the third quantization result, to obtain the compressed data, where the compressed data includes a second bitmap, one bit in the second bitmap corresponds to one element in the second part of elements, and the second bitmap indicates whether an element in the second part of elements is matched with an element in the first part of elements.

In a possible implementation, an arrangement order of elements corresponding to bits in the second bitmap is the same as a compression encoding or decoding order of elements in the second part of elements.

In a possible implementation, the compressed data includes first compressed sub-data and second compressed sub-data, the first compressed sub-data corresponds to the first differential data, the second compressed sub-data corresponds to the third differential data, an order of elements in the first compressed sub-data corresponds to a decoding order of elements in the second group of data at the receiver, an order of elements in the second compressed sub-data corresponds to a decoding order of elements in a third part of elements at the receiver, and the third part of elements are an element that is in the second part of elements and that is matched with an element in the first part of elements.

In a possible implementation, the compressed data further includes third indication information, and the third indication information indicates whether the compressed data is obtained in a differential manner.

In a possible implementation, the compressed data further includes fourth indication information, and the fourth indication information indicates whether a transmitter successfully decodes acknowledgment ACK signaling that is most recently fed back by the receiver for data from the transmitter.

For the possible implementations of the communication method in the third aspect, refer to the possible implementations of the first aspect.

For technical effect brought by the possible implementations of the third aspect, refer to the descriptions of the technical effect of the first aspect or the possible implementations of the first aspect.

According to a fourth aspect, an embodiment of this application provides a communication apparatus. The communication apparatus has a function of implementing behavior in the method embodiment in the second aspect. The communication apparatus may be a communication device, may be a component (for example, a processor, a chip, or a chip system) of the communication device, or may be a logical module or software that can implement all or some functions of the communication device. The function of the communication apparatus may be implemented by hardware, or may be implemented by hardware executing corresponding software. The hardware or the software includes one or more modules or units corresponding to the foregoing function. In a possible implementation, the communication apparatus includes a transceiver unit and a processing unit. The transceiver unit is configured to receive compressed data from a transmitter. The processing unit is configured to decode the compressed data, to obtain first differential data; and add each element in the first differential data and a reference element corresponding to each element, to obtain a first group of data, where each element in the first differential data corresponds to one element in a second group of data, a reference element of a first element in the first differential data is an element corresponding to the first element in the second group of data, the second group of data is data that has been successfully received by a receiver, and the first element is any element in the first differential data.

In a possible implementation, the compressed data includes first indication information, and the first indication information indicates a first group of entropy encoding parameters; and the processing unit is configured to determine the first group of entropy encoding parameters based on the first indication information; and separately decode data in a corresponding dimension in the compressed data by using an entropy encoding parameter in each dimension in the first group of entropy encoding parameters, to obtain the first differential data.

In a possible implementation, the compressed data includes a first bitmap, one bit in the first bitmap corresponds to one element in the second group of data, and the first bitmap indicates whether an element in the second group of data is matched with an element in the first group of data; and the processing unit is further configured to determine, based on the first bitmap, the reference element corresponding to each element in the first differential data.

In a possible implementation, an arrangement order of elements corresponding to bits in the first bitmap is the same as a compression encoding or decoding order of elements in the second group of data.

In a possible implementation, the compressed data further includes second indication information, the second indication information indicates a quantity of third data groups, and the second group of data is obtained by combining two or more third data groups.

In a possible implementation, an order of elements in the compressed data corresponds to a decoding order of elements in the second group of data at the receiver.

In a possible implementation, the processing unit is specifically configured to decode the compressed data, to obtain the first differential data and third differential data, where the compressed data includes a second bitmap, one bit in the second bitmap corresponds to one element in the first differential data, and the second bitmap indicates whether an element in the first differential data is matched with an element in the third differential data; and the adding each element in the first differential data and the reference element corresponding to each element, to obtain the first group of data includes: adding each element in the first differential data and the reference element corresponding to each element, and adding each element in the third differential data and a reference element corresponding to each element, to obtain the first group of data, where a reference element corresponding to a second element in the third differential data is a sum of a third element corresponding to the second element in the first differential data and a reference element corresponding to the third element, and the second element is any element in the third differential data.

In a possible implementation, an arrangement order of elements corresponding to bits in the second bitmap is the same as a compression encoding or decoding order of elements in the first differential data.

In a possible implementation, an order of elements in the first differential data corresponds to a decoding order of elements in the second group of data at the receiver, and an order of elements in the third differential data corresponds to a decoding order, at the receiver, of elements that are in the first differential data and that are associated with the third differential data.

In a possible implementation, the compressed data further includes third indication information, and the third indication information indicates whether the compressed data is obtained in a differential manner.

In a possible implementation, the compressed data further includes fourth indication information, and the fourth indication information indicates whether a transmitter successfully decodes acknowledgment ACK signaling that is most recently fed back by the receiver for data from the transmitter.

According to a fifth aspect, an embodiment of this application provides another communication apparatus. The communication apparatus includes a processor, the processor is coupled to a memory, the memory is configured to store a program or instructions, and when the program or the instructions are executed by the processor, the communication apparatus is enabled to perform the method in the first aspect or the second aspect.

In this embodiment of this application, in a process of performing the method, a process of sending information (or a signal) in the method may be understood as a process of outputting information based on instructions of the processor. When the information is output, the processor outputs the information to a transceiver, so that the transceiver transmits the information. After the information is output by the processor, the information may further require other processing, and then reaches the transceiver. Similarly, when the processor receives input information, the transceiver receives the information, and inputs the information into the processor. Further, after the transceiver receives the information, other processing may need to be performed on the information before the information is input into the processor.

Operations such as sending and/or receiving related to the processor may be generally understood as output based on instructions of the processor, unless otherwise specified, or if the operations do not conflict with actual functions or internal logic of the operations in related descriptions.

In an implementation process, the processor may be a processor specially configured to perform these methods, or may be a processor that executes computer instructions in a memory to perform these methods, for example, a general-purpose processor. For example, the processor may be further configured to execute a program stored in the memory, and when the program is executed, the communication apparatus is enabled to perform the method shown in any one of the first aspect or the possible implementations of the first aspect.

In a possible implementation, the memory is located outside the communication apparatus. In a possible implementation, the memory is located inside the communication apparatus.

In a possible implementation, the processor and the memory may alternatively be integrated into one component, that is, the processor and the memory may alternatively be integrated together.

In a possible implementation, the communication apparatus further includes the transceiver. The transceiver is configured to receive or send a signal, and the like.

According to a sixth aspect, this application provides another communication apparatus. The communication apparatus includes a processing circuit and an interface circuit, the interface circuit is configured to obtain data or output data, and the processing circuit is configured to perform the method in the first aspect or the second aspect.

According to a seventh aspect, this application provides a computer-readable storage medium. The computer-readable storage medium stores a computer program, the computer program includes program instructions, and when the program instructions are executed, a computer is enabled to perform the method in the first aspect or the second aspect.

According to an eighth aspect, this application provides a computer program product. The computer program product includes a computer program, the computer program includes program instructions, and when the program instructions are executed, a computer is enabled to perform the method in the first aspect or the second aspect.

According to a ninth aspect, this application provides a communication system, including the communication apparatus in any one of the third aspect or the possible implementations of the third aspect, and the communication apparatus in any one of the fourth aspect or the possible implementations of the fourth aspect.

According to a tenth aspect, this application provides a chip, including a processor and a communication interface. The processor reads, through the communication interface, instructions stored in a memory, to perform the method in the first aspect or the second aspect.

**BRIEF DESCRIPTION OF DRAWINGS**

To describe the technical solutions in embodiments of this application or in the background more clearly, the following describes the accompanying drawings for describing embodiments of this application or the background.

FIG. 1 is a principle diagram of each path of ray tracing according to an embodiment of this application;

FIG. 2 is a diagram of definitions of a horizontal angle and a vertical angle of an angle of departure/angle of arrival according to an embodiment of this application;

FIG. 3 shows an example of a scenario in which a receiver slowly moves according to an embodiment of this application;

FIG. 4 is a diagram of ray tracing angle-of-arrival data at two adjacent moments according to an embodiment of this application;

FIG. 5 is a diagram of an architecture of a communication system 1000 to which an embodiment of this application is applied;

FIG. 6 is a flowchart of a data compression method according to an embodiment of this application;

FIG. 7 is a diagram of matching an element in a first group of data with an element in a second group of data according to an embodiment of this application;

FIG. 8 is a diagram of a loss function calculation method for a matching optimization problem according to an embodiment of this application;

FIG. 9 is a flowchart of a method for matching an element in a first group of data with an element in a second group of data according to an embodiment of this application;

FIG. 10 is a flowchart of a method for matching an element in a first group of data with an element in a second group of data according to an embodiment of this application;

FIG. 11 shows an example of content exchanged between a transmitter and a receiver according to an embodiment of this application;

FIG. 12 is a diagram of matching when a quantity of elements in a first group of data is less than a quantity of elements in a second group of data according to an embodiment of this application;

FIG. 13 is a diagram of content in compressed data according to an embodiment of this application;

FIG. 14 is a diagram of matching when a quantity of elements in a first group of data is greater than a quantity of elements in a second group of data according to an embodiment of this application;

FIG. 15 is a diagram of content in compressed data according to an embodiment of this application;

FIG. 16 is a flowchart of a data compression method according to an embodiment of this application;

FIG. 17 is a flowchart of a data compression method according to an embodiment of this application;

FIG. 18 shows an example of content in compressed data according to an embodiment of this application;

FIG. 19 is a flowchart of another data compression method according to an embodiment of this application;

FIG. 20A is a diagram of a feedback signaling design and interaction procedure in a basic mode according to an embodiment of this application;

FIG. 20B is a diagram of a feedback signaling design and interaction procedure in an enhanced mode according to an embodiment of this application;

FIG. 21 is a diagram of a structure of a communication apparatus 2100 according to an embodiment of this application;

FIG. 22 is a diagram of a structure of another communication apparatus 220 according to an embodiment of this application; and

FIG. 23 is a diagram of a structure of another communication apparatus 230 according to an embodiment of this application.

## DESCRIPTION OF EMBODIMENTS

The terms "first", "second", and the like in the specification, claims, and accompanying drawings of this application are used to distinguish between different objects, but are not used to describe a specific sequence. It may be understood that various numbers in embodiments of this application are merely used for differentiation for ease of description, and are not used to limit the scope of embodiments of this application. Sequence numbers of the foregoing processes do not mean an execution sequence, and the execution sequence of the processes should be determined based on functions and internal logic of the processes. In addition, the terms "including" and "having" and any other variants thereof are intended to cover non-exclusive inclusion. For example, a process, a method, a system, a product, or a device that includes a series of steps or units is not limited to the listed steps or units, but optionally further includes an unlisted step or unit, or optionally further includes another step or unit inherent to the process, the method, the product, or the device.

"Embodiment" mentioned in this specification means that a particular feature, structure, or characteristic described with reference to the embodiment may be included in at least one embodiment of this application. The phrase shown in various locations in the specification may not necessarily refer to a same embodiment, and is not an independent or optional embodiment exclusive from another embodiment. It is explicitly and implicitly understood by a person skilled in the art that embodiments described in this specification may be combined with another embodiment.

Terms used in the following embodiments of this application are merely intended to describe specific embodiments, but are not intended to limit this application. The terms "one", "a", "an", "the", and "this" of singular forms used in this specification and the appended claims of this application are also intended to include plural forms, unless otherwise specified in the context clearly. It should also be understood that the term "and/or" used in this application means and includes any or all possible combinations of one or more listed items. For example, "A and/or B" may represent three cases: Only A exists, only B exists, and both A and B exist, where A and B may be singular or plural. The term "multiple" used in this application means two or more. In text descriptions of this application, the character "/" generally represents an "or" relationship between associated objects. The term "at least one" used in this application means one or more.

It may be understood that in embodiments of this application, "B corresponding to A" indicates that there is a correspondence between A and B, and B may be determined based on A. However, it should be further understood that determining (or generating) B based on (or according to) A does not mean that B is determined (or generated) based only on (or according to) A, and B may alternatively be determined (or generated) based on (or according to) A and/or other information.

For ease of understanding of solutions of this application, the following first describes terms in embodiments of this application.

**Air interface time-related data with time correlation**

If two groups of data sent by a transmitter at different moments have strong correlation, the two groups of data may be considered as air interface time-related data having time correlation. It is assumed that there is strong correlation between elements $\{x_1, x_2, ..., x_N\}$ in a group of data to be sent by the transmitter and elements $\{y_1, y_2, ..., y_N\}$ in another group of data (obtained by a receiver), and the two groups of data may be considered as air interface time-related data having time correlation. The air interface time-related data having time correlation may be, for example, ray tracing data, multi-target positioning data, or CSI data. In this application, the ray tracing data is used as an example to show how to compress and decompress the air interface time-related data having time correlation.

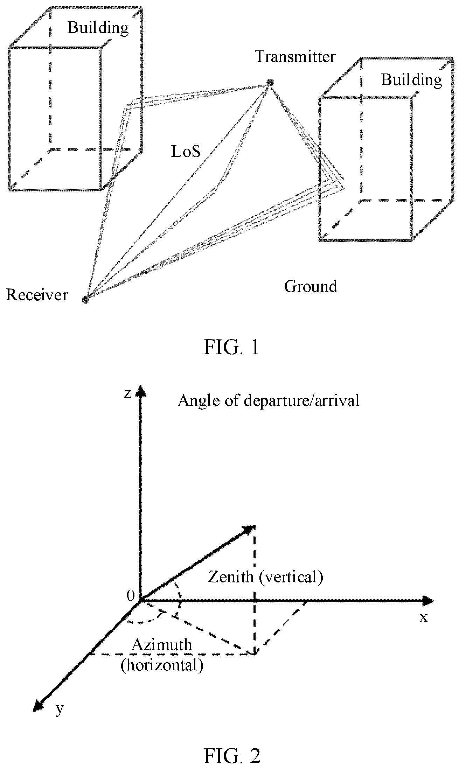

The ray tracing data mainly includes data of multiple ray paths. Each path has a delay, a path loss, an angle of departure (classified into a horizontal angle of departure and a vertical angle of departure), and an angle of arrival (also classified into a horizontal angle of arrival and a vertical angle of arrival). A principle diagram of each path of ray tracing is shown in FIG. 1. FIG. 1 is a principle diagram of each path of ray tracing according to an embodiment of this application. In FIG. 1, two cuboids represent buildings (building), and there are multiple ray paths between a transmitter (transmitter) and a receiver (receiver), where LoS (line of sight) represents a line of sight path between the transmitter and the receiver, and ground represents the ground. FIG. 2 is a diagram of definitions of a horizontal angle and a vertical angle of an angle of departure (angle of departure)/angle of arrival (angle of arrival) according to an embodiment of this application. As shown in FIG. 2, an azimuth (azimuth) is a horizontal (horizontal) angle, the horizontal angle is an included angle between a projection of a connection line between an origin and a zenith (zenith) on a horizontal plane (xy plane) and a y-axis, and a vertical (vertical) angle is an included angle between the connection line between the origin and the zenith and the horizontal plane.

The ray tracing data may be compactly represented in a form of a high-dimensional vector group $\{x_1, x_2, ..., x_N\}$, where each $x_i$ is a multi-dimensional vector (corresponding to an angle, a path loss, a delay, or the like in the ray tracing data), and $N$ is a quantity of to-be-transmitted data points (that is, a quantity of paths of ray tracing). Actually, many other air interface native data may also be written in such a form. For example, corresponding to multi-target positioning data, $N$ is a quantity of positioning targets, and each $x_i$ corresponds to location coordinates of an $i^{th}$ target. Both the ray tracing data and the multi-target positioning data are generated by an air interface (air interface) of a cellular system, and are not data generated by an upper-layer application. In addition, a main function of the ray tracing data and the multi-target positioning data is to assist air interface communication performance, and therefore, the ray tracing data and the multi-target positioning data are referred to as air interface native data. Currently, air interface native data widely known in a 5G system is CSI data.

The ray tracing data is usually used mainly to estimate large-scale channel fading, assist network optimization, and the like. In a future communication system, a sensing capability and environment modeling accuracy are to be greatly improved. The ray tracing data can be used to accurately estimate some main-path information. The ray tracing data is directly used for assistance communication (such as assistance beam management and assistance channel estimation), including but not limited to the following scenarios:

A terminal device feeds back some main-path data of ray tracing to assist a base station in downlink precoding and beam management.

The base station uses the ray tracing data to assist downlink precoding (without a compression requirement).

The terminal device feeds back some main-path data of ray tracing to assist the base station in downlink precoding.

The base station delivers some main-path data of ray tracing to assist the terminal device in downlink reception or uplink transmission.

In a sidelink scenario, a base station obtains some main-path data between devices based on location information of a terminal device, and delivers the some main-path data to assist communication between devices.

In the foregoing scenarios, a transmitter (which may be referred to as Tx for short) sends several pieces of main-path information (such as a delay/path loss/angle of arrival) obtained through ray tracing to a receiver (which may be referred to as Rx for short). Compression and transmission of the ray tracing data need to meet a given accuracy requirement based on a specific application scenario. For example, for delay (delay) data, an error between a delay of each path that is decompressed and restored at the receiver and a delay of original data is required to be strictly less than a given upper bound $\varepsilon$, and $\varepsilon$ depends on a bandwidth (time resolution) of the receiver and an application scenario. Compression accuracy requirements for angle data and path loss data are similar. Clearly, these requirements are also applicable to compression feedback of other air interface native data. Herein, only the ray tracing data is used as an example for description.

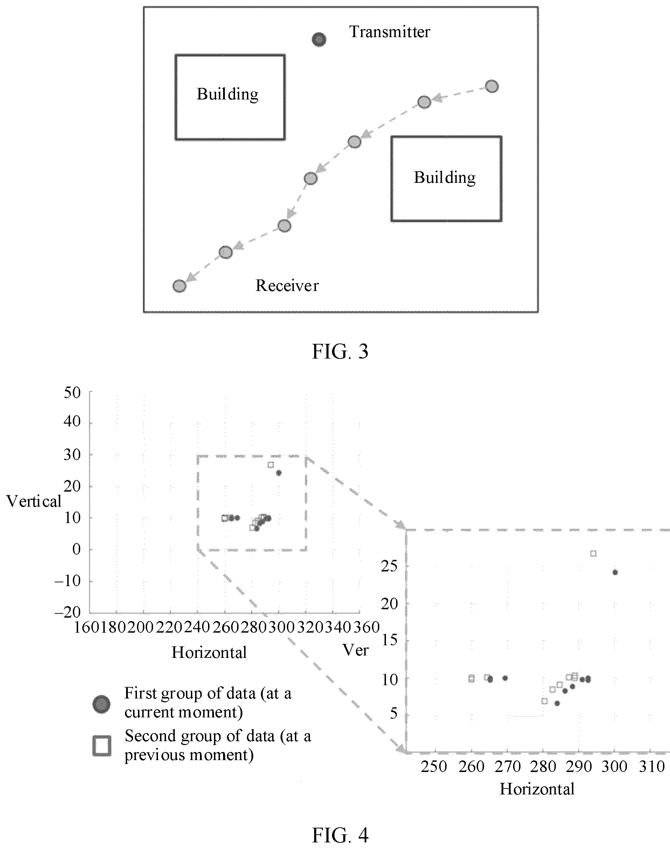

The following uses angle of arrival time-related data of ray tracing as an example for description. The solutions provided in this application is also applicable to compression and transmission of other air interface time-related data having time correlation, for example, data such as locations and speeds of multiple targets that are sensed. For time-related data in the ray tracing scenario, a typical example is that a location of a transmitter is fixed, an electromagnetic reflection environment around the transmitter is also static, and a receiver slowly moves along a path, as shown in FIG. 3 below. FIG. 3 shows an example of a scenario in which a receiver slowly moves according to an embodiment of this application. In the scenario shown in FIG. 3, a diagram of angle-of-arrival data obtained by performing ray tracing at two adjacent moments (that is, a previous moment and a current moment) is shown in FIG. 4. FIG. 4 is a diagram of ray tracing angle-of-arrival data at two adjacent moments according to an embodiment of this application. As shown in FIG. 4, a circle represents angle-of-arrival data obtained by performing ray tracing at a current moment, that is, a first group of data; and a square represents angle-of-arrival data obtained by performing ray tracing at a previous moment, that is, a second group of data. It can be learned from FIG. 4 that the first group of data and the second group of data in FIG. 4 are strongly correlated.

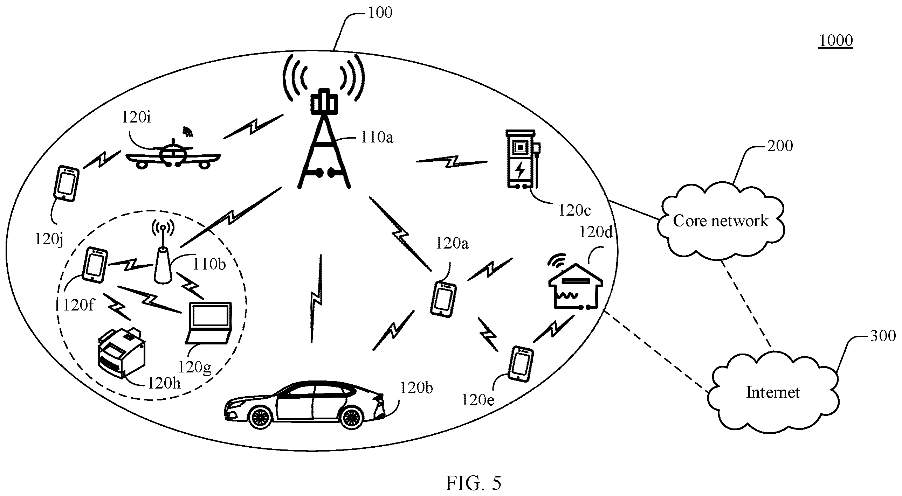

FIG. 5 is a diagram of an architecture of a communication system 1000 to which an embodiment of this application is applied. As shown in FIG. 5, the communication system includes a radio access network 100 and a core network 200. Optionally, the communication system 1000 may further include an internet 300. The radio access network 100 may include at least one radio access network device (for example, 110a and 110b in FIG. 5), and may further include at least one terminal (for example, 120a to 120j in FIG. 5). The terminal (that is, the terminal device) is connected to the radio access network device in a wireless manner, and the radio access network device is connected to the core network in a wireless or wired manner. A core network device and the radio access network device may be independent and different physical devices, or functions of the core network device and logical functions of the radio access network device are integrated into a same physical device, or some functions of the core network device and some functions of the radio access network device are integrated into one physical device. A wired or wireless manner may be used for connection between terminals and between radio access network devices. FIG. 5 is merely a diagram. The communication system may further include another network device, for example, a wireless relay device and a wireless backhaul device, which are not shown in FIG. 5.

The radio access network device is an access device used by the terminal to access the communication system in a wireless manner. The radio access network device may be a base station (base station), an evolved NodeB (evolved NodeB, eNodeB), a transmission reception point (transmission reception point, TRP), a next generation NodeB (next generation NodeB, gNB) in a 5th generation (5th generation, 5G) mobile communication system, a next generation base station in a 6th generation (6th generation, 6G) mobile communication system, a base station in a future mobile communication system, an access node in a Wi-Fi system, or the like; or may be a module or unit that completes a part of functions of the base station, for example, may be a central unit (central unit, CU), or may be a distributed unit (distributed unit, DU). The CU herein completes functions of a radio resource control protocol and a packet data convergence protocol (packet data convergence protocol, PDCP) of the base station, and may further complete a function of a service data adaptation protocol (service data adaptation protocol, SDAP). The DU completes functions of a radio link control layer and a medium access control (medium access control, MAC) layer of the base station, and may further complete a part or all of functions of a physical layer. For specific descriptions of the foregoing protocol layers, refer to related technical specifications of the 3rd generation partnership project (3rd generation partnership project, 3GPP). The radio access network device may be a macro base station (like 110a in FIG. 5), may be a micro base station or an indoor base station (like 110b in FIG. 5), or may be a relay node or a donor node. A specific technology and a specific device form used by the radio access network device are not limited in embodiments of this application. For ease of description, the following uses an example in which a base station is used as a radio access network device for description.

The terminal is a device having a wireless transceiver function, and may send a signal to the base station, or receive a signal from the base station. The terminal may also be referred to as a terminal device, user equipment (user equipment, UE), a mobile station, a mobile terminal, or the like. The terminal may be widely used in various scenarios, for example, device-to-device (device-to-device, D2D), vehicle to everything (vehicle to everything, V2X) communication, machine-type communication (machine-type communication, MTC), internet of things (internet of things, IoT), virtual reality, augmented reality, industrial control, automatic driving, telemedicine, a smart grid, smart furniture, a smart office, smart wearable, smart transportation, and a smart city. The terminal may be a mobile phone, a tablet computer, a computer having a wireless transceiver function, a wearable device, a vehicle, an airplane, a ship, a robot, a robotic arm, a smart home device, or the like. A specific technology and a specific device form that are used by the terminal are not limited in embodiments of this application.

The base station and the terminal may be fixed or movable. The base station and the terminal may be deployed on land, including an indoor or outdoor device, a hand-held device, or a vehicle-mounted device, or may be deployed on water, or may be deployed on an airplane, a balloon, or an artificial satellite. Application scenarios of the base station and the terminal are not limited in embodiments of this application.

Roles of the base station and the terminal may be relative. For example, a helicopter or an uncrewed aerial vehicle 120i in FIG. 5 may be configured as a mobile base station. For a terminal 120j accessing the radio access network 100 through 120i, the terminal 120i is a base station. However, for the base station 110a, 120i is a terminal. In other words, communication between 110a and 120i is performed according to a radio air interface protocol. Certainly, communication between 110a and 120i may alternatively be performed according to an interface protocol between the base stations. In this case, for 110a, 120i is also a base station. Therefore, both the base station and the terminal may be collectively referred to as communication apparatuses, 110a and 110b in FIG. 5 may be referred to as communication apparatuses having a base station function, and 120a to 120j in FIG. 5 may be referred to as communication apparatuses having a terminal function.

Communication between the base station and the terminal, between the base stations, or between the terminals may be performed by using a licensed spectrum, or may be performed by using an unlicensed spectrum, or may be performed by using both the licensed spectrum and the unlicensed spectrum. Communication may be performed by using a spectrum below 6 gigahertz (gigahertz, GHz), or may be performed by using a spectrum above 6 GHz, or may be simultaneously performed by using the spectrum below 6 GHz and the spectrum above 6 GHz. A spectrum resource used for wireless communication is not limited in embodiments of this application.

In embodiments of this application, a function of the base station may be performed by a module (for example, a chip) in the base station, or may be performed by a control subsystem including the function of the base station. The control subsystem including the function of the base station herein may be a control center in the foregoing application scenarios, such as a smart grid, industrial control, smart transportation, and a smart city. The function of the terminal may alternatively be performed by a module (for example, a chip or a modem) in the terminal, or may be performed by an apparatus including the function of the terminal.

In this application, the base station sends a downlink signal or downlink information to the terminal, where the downlink information is carried on a downlink channel; and the terminal sends an uplink signal or uplink information to the base station, where the uplink information is carried on an uplink channel. To communicate with the base station, the terminal needs to establish a wireless connection to a cell controlled by the base station. The cell that establishes the wireless connection to the terminal is referred to as a serving cell of the terminal. When communicating with the serving cell, the terminal is further interfered by a signal from a neighboring cell.

The following describes a data compression solution and a data decompression solution provided in this application with reference to the accompanying drawings.

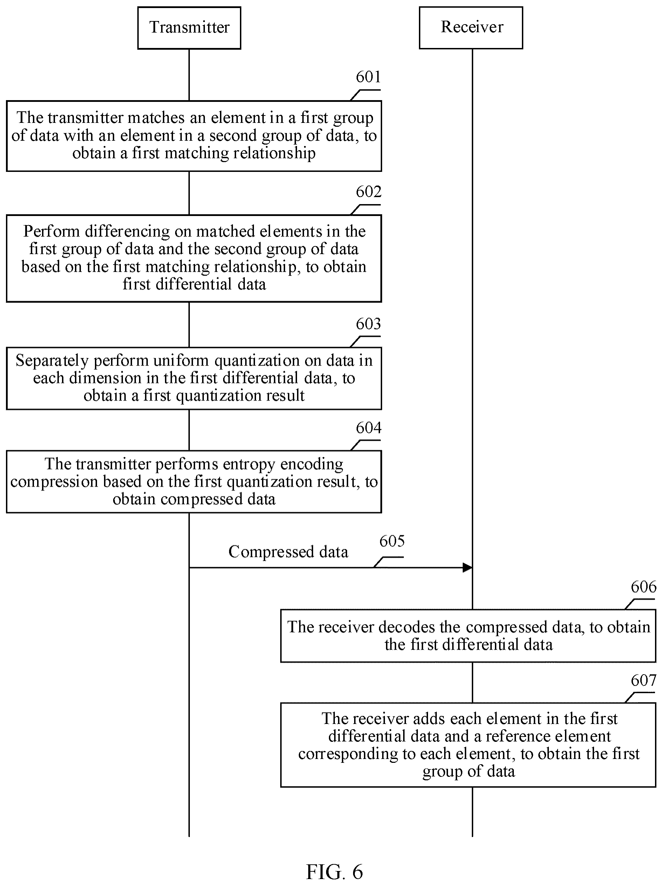

FIG. 6 is a flowchart of a data compression method according to an embodiment of this application. As shown in FIG. 6, the method includes the following steps.

601: A transmitter matches an element in a first group of data with an element in a second group of data, to obtain a first matching relationship.

The first group of data is data to be received by a receiver (which may be referred to as Rx for short), and the second group of data is data that has been successfully received by the receiver. The first group of data may be understood as data to be sent by the transmitter (which may be referred to as Tx for short) to the receiver. The first group of data and the second group of data are data of a same type. The first group of data and the second group of data may be air interface time-related data having time correlation. For example, both the first group of data and the second group of data are ray tracing data, multi-target positioning data, CSI data, or the like. For example, the second group of data is ray tracing data sent by the transmitter to the receiver at a moment 1, the second group of data is successfully received by the receiver, the first group of data is ray tracing data that needs to be sent by the transmitter to the receiver at a current moment, and the moment 1 is a previous moment of the current moment. The first matching relationship indicates a matching relationship between an element in the first group of data and an element in the second group of data. For example, the first group of data includes an element A1, an element A2, an element A3, ..., and an element A6, a quantity of elements in the first group of data and an order of the elements are not limited, the second group of data includes an element B1, an element B2, an element B3, ..., and an element B6, a quantity of elements in the second group of data and an order of the elements are not limited, and the first matching relationship indicates that A1 is matched with B1, A2 is matched with B2, A3 is matched with B3, ..., and A6 is matched with B6. Each element in the first group of data is an m-dimensional vector, each element in the second group of data is an m-dimensional vector, and m is an integer greater than 0. For example, m is 1, 2, 3, 4, or 5.

To fully use correlation between two groups of data (that is, the first group of data and the second group of data), this embodiment of this application provides a solution of optimizing a matching relationship between two groups of elements, and an objective is to directly minimize a compressed codeword length. A possible implementation of step 601 is described in detail subsequently.

602: Perform differencing on matched elements in the first group of data and the second group of data based on the first matching relationship, to obtain first differential data.

For example, the first group of data includes an element A1, an element A2, an element A3, ..., and an element A6, a quantity of elements in the first group of data and an order of the elements are not limited, the second group of data includes an element B1, an element B2, an element B3, ..., and an element B6, a quantity of elements in the second group of data and an order of the elements are not limited, and the first matching relationship indicates that A1 is matched with B1, A2 is matched with B2, A3 is matched with B3, ..., and A6 is matched with B6. An example of step 602 is as follows: Calculate a value of A1 minus B1 to obtain C1; calculate a value of A2 minus B2 to obtain C2; calculate a value of A3 minus B3 to obtain C3, and so on. The first differential data includes C1, C2, C3, ..., and C6.

603: Separately perform uniform quantization on data in each dimension in the first differential data, to obtain a first quantization result.

A possible implementation of step 603 is as follows: Separately perform uniform quantization on the data in each dimension in the first differential data based on preset error accuracy (that is, quantization error accuracy of the data in each dimension), to obtain the first quantization result. For example, before data transmission, the transmitter and the receiver may configure quantization error accuracy of the data in each dimension and an entropy encoding (for example, Golomb encoding) parameter set (not required for LZ encoding or adaptive arithmetic coding) in each dimension, and the entropy encoding parameter set in each dimension is optional. In this implementation, uniform quantization is separately performed on the data in each dimension in the first differential data based on the preset error accuracy, which can ensure an absolute accuracy requirement of decompressed data. A technical objective to be achieved in step 603 is to quantize the first differential data based on the preset error accuracy. The transmitter may alternatively quantize the first differential data in another manner provided that the preset error accuracy can be met.

604: The transmitter performs entropy encoding compression based on the first quantization result, to obtain compressed data.

A possible implementation of step 604 is as follows: Transform the first quantization result into a nonnegative integer, to obtain a first transformation result; and perform entropy encoding compression on the first transformation result, to obtain the compressed data.

A possible manner in which the transmitter transforms the first quantization result into the nonnegative integer is as follows: Take an absolute value of the first quantization result. In this manner, sign bits of all elements also need to be reserved and sent to the receiver. In other words, the first transformation result is an absolute value of the first quantization result. A possible manner in which the transmitter transforms the first quantization result into the nonnegative integer is as follows: First determine a value range [ymin, ymax] (where ymin is negative and ymax is positive) of the first quantization result (denoted as t), and mark a smaller absolute value in ymin and ymax as T=min {|ymin|, |ymax|}; and then, transform t into a nonnegative integer by using the following transformation f(t):

$$
f(t) = \begin{cases} 2t, & 0 \le t \le T \\ 2|t| - 1, & -T \le t < 0 \\ t + T, & otherwise \end{cases}
$$

The transmitter may perform entropy encoding compression based on the first quantization result by using different entropy encoding. For example, the transmitter may use LZ encoding, arithmetic coding (without an entropy encoding parameter), Huffman encoding (with an entropy encoding parameter), Golomb encoding (with an entropy encoding parameter), and the like. LZ encoding is short for Lempel-Ziv encoding.

605: The transmitter sends the compressed data to the receiver.

Correspondingly, the receiver receives the compressed data from the transmitter.

In a possible implementation, when a quantity of elements in the first group of data is less than a quantity of elements in the second group of data, the compressed data includes a first bitmap, one bit in the first bitmap corresponds to one element in the second group of data, and the first bitmap indicates whether an element in the second group of data is matched with an element in the first group of data. A length of the first bitmap is equal to the quantity of elements in the second group of data. Optionally, an arrangement order of elements corresponding to bits in the first bitmap is the same as a compression encoding or decoding order of elements in the second group of data. For example, the first group of data includes six elements, the second group of data includes eight elements, and the first bitmap is 11100111. An arrangement order of elements corresponding to bits in the first bitmap is the same as a compression encoding or decoding order of elements in the second group of data. An element corresponding to a bit whose bit value is 1 in the first bitmap is matched with an element in the first group of data, and an element corresponding to a bit whose bit value is 0 in the first bitmap is not matched with an element in the first group of data. In this example, the first bitmap indicates that a 1st element to a 3rd element (ordered in a compression or decompression order) and a 6th element to an 8th element in the second group of data is matched with elements in the first group of data. For another example, the first group of data includes six elements, the second group of data includes eight elements, and the first bitmap is 00011000. An arrangement order of elements corresponding to bits in the first bitmap is the same as a compression encoding or decoding order of elements in the second group of data. An element corresponding to a bit whose bit value is 0 in the first bitmap is matched with an element in the first group of data, and an element corresponding to a bit whose bit value is 1 in the first bitmap is not matched with an element in the first group of data. In this example, the first bitmap indicates that a $1^{st}$ element to a $3^{rd}$ element (ordered in a compression or decompression order) and a $6^{th}$ element to an $8^{th}$ element in the second group of data is matched with elements in the first group of data. In this implementation, the compressed data includes the first bitmap, so that the receiver determines the matching relationship between the element in the second group of data and the element in the first group of data based on the first bitmap.

In a possible implementation, the compressed data further includes second indication information, and the second indication information indicates a quantity of third data groups. The second group of data is a group of data that has been successfully received by the receiver, that is, a third data group. Alternatively, the second group of data is obtained by combining two or more third data groups. The transmitter and the receiver may first configure a set $\mathcal{N}$ of quantities that can be selected, and then use the second indication information (for example, a subscript) to indicate a selected quantity. For example, $\mathcal{N} = \{1, 2, 3, 4\}$. 00 (the second indication information) represents 1, 01 represents 2, 10 represents 3, and 11 represents 4, which are agreed on by the transmitter and the receiver. For example, the transmitter needs to send the first group of data to the receiver at the current moment, and the transmitter has sent the second group of data to the receiver at the previous moment and the second group of data is successfully received by the receiver. The transmitter uses the second group of data as a data group for sending the first group of data, and then performs step 601 to step 605 to obtain the compressed data. The second indication information in the compressed data is 00, and the second indication information indicates that a quantity of third data groups is 1. In other words, the first indication information indicates that a data group referenced for sending the first group of data by the transmitter is the second group of data sent at the previous moment. For another example, the transmitter needs to send the first group of data to the receiver at the current moment, the transmitter has sent a group of data $\{y_1, y_2, ..., y_{N_2}\}$ to the receiver at the previous moment and the group of data is successfully received by the receiver, and the transmitter has sent a group of data $\{z_1, z_2, ..., z_{N_3}\}$ to the receiver at a previous moment of the previous moment and the group of data is successfully received by the receiver. The transmitter may combine $\{y_1, y_2, ..., y_{N_2}\}$ and $\{z_1, z_2, ..., z_{N_3}\}$ into a new group of data $\{y_1, y_2, ..., y_{N_2}, z_1, z_2, ..., z_{N_3}\}$, that is, the second group of data. The transmitter uses the second group of data as a data group for sending the first group of data, and then performs step 601 to step 605 to obtain the compressed data. The second indication information in the compressed data is 01, and the second indication information indicates that a quantity of third data groups is 2. In other words, the second indication information indicates that a data group referenced for sending the first group of data by the transmitter is a group of data (that is, $\{y_1, y_2, ..., y_{N_2}\}$) sent by the transmitter at the previous moment and a group of data sent at the previous moment of the previous moment, that is, $\{z_1, z_2, ..., z_{N_3}\}$. In this application, the current moment is a moment at which the transmitter is to send the first group of data, the previous moment is a moment at which the transmitter sends a group of data having time correlation with the first group of data last time, and the previous moment of the previous moment is a moment at which the transmitter sends a group of data having time correlation with the first group of data last time of last time. In this implementation, the compressed data further includes the second indication information, so that the receiver can determine the quantity of third data groups.

In a possible implementation, an order of elements in the compressed data corresponds to a decoding order of elements in the second group of data at the receiver. In other words, an order of elements obtained by compressing elements in the first group of data in the compressed data corresponds to a decoding order of elements in the second group of data at the receiver. For example, the first group of data includes an element A1, an element A2, an element A3, ..., and an element A6, the second group of data includes six elements in total: an element B1, an element B2, an element B3, ..., and an element B6, a decoding order of elements in the second group of data at the receiver is: B2, B3, B4, B1, B5 and B6 sequentially, and the first matching relationship is that A1 is matched with B1, A2 is matched with B2, A3 is matched with B3, ..., and A6 is matched with B6. An example of step 602 is as follows: Calculate a value of A1 minus B1 to obtain C1; calculate a value of A2 minus B2 to obtain C2; calculate a value of A3 minus B3 to obtain C3, and so on. The first differential data includes C1, C2, C3, ..., and C6. The first quantization result obtained in step 603 includes D1, D2, D3, ..., and D6. The compressed data obtained in step 604 includes E1, E2, E3, ..., and E6. E1 may be considered as an element obtained by compressing A1, E2 may be considered as data obtained by compressing A2, E3 may be considered as data obtained by compressing A3, and so on. In this example, an order of the elements (that is, E1, E2, E3, ..., and E6) obtained by compressing the elements in the first group of data in the compressed data obtained in step 604 is E2, E3, E4, E1, E5, and E6. It should be understood that the transmitter may correspondingly adjust an order of elements in the compressed data in the decoding order of elements in the second group of data at the receiver, so that the order of elements in the compressed data corresponds to the decoding order of elements in the second group of data at the receiver. In this implementation, the receiver can perform decoding more quickly, and a decoding workload is reduced.

In a possible implementation, the compressed data further includes third indication information, and the third indication information indicates whether the compressed data is obtained in a differential manner.

In a possible implementation, the compressed data further includes fourth indication information, and the fourth indication information indicates whether a transmitter successfully decodes acknowledgment ACK (Acknowledgment) signaling that is most recently fed back by the receiver for data from the transmitter. In this implementation, the compressed data further includes the fourth indication information, to determine data referenced by the compressed data sent by the transmitter.

606: The receiver decodes the compressed data, to obtain the first differential data.

The transmitter and the receiver are different terminals. Alternatively, the transmitter and the receiver are different access network devices, for example, base stations. Alternatively, the transmitter is a terminal, and the receiver is an access network device. Alternatively, the transmitter is an access network device, and the receiver is a terminal. That the receiver decodes the compressed data, to obtain the first differential data may be: The receiver obtains, based on the compressed data, differential data in each dimension (row by row) through decoding, to obtain the first differential data. For example, the elements in the compressed data are E2, E3, E4, E1, E5 and E6 sequentially in the decoding order, and the first differential data is C2, C3, C4, C1, C5, and C6 sequentially in the decoding order. C1 may be considered to be obtained by decoding E1, C2 may be considered to be obtained by decoding E2, and so on.

607: The receiver adds each element in the first differential data and a reference element corresponding to each element, to obtain the first group of data.

Each element in the first differential data corresponds to one element in the second group of data. A reference element of the first element in the first differential data is an element corresponding to the first element in the second group of data. The second group of data is data that has been successfully received by the receiver. The first element is any element in the first differential data. For example, the elements in the first differential data are C2, C3, C4, C1, C5 and C6 sequentially in the decoding order, the elements in the second group of data are B2, B3, B4, B1, B5, B6 sequentially in the decoding order, a reference element corresponding to C2 is B2, a reference element corresponding to C3 is B2, a reference element corresponding to C4 is B4, a reference element corresponding to C1 is B1, a reference element corresponding to C5 is B5, and a reference element corresponding to C6 is B6. An example of step 607 is as follows: Add C2 and B2 to obtain an element A2, add C3 and B3 to obtain an element A3, add C4 and B4 to obtain an element A4, add C1 and B1 to obtain an element A1, add C5 and B5 to obtain an element A5, and add C6 and B6 to obtain an element A6. The elements in the first group of data are A2, A3, A4, A1, A5 and A6 sequentially in the decoding order.

In this embodiment of this application, differencing is performed on the matched elements in the first group of data and the second group of data, to obtain the first differential data. Therefore, a time correlation characteristic of data can be effectively used, to reduce an amount of data that needs to be compressed. Uniform quantization is separately performed on data in each dimension in the first differential data, to obtain the first quantization result, so that absolute accuracy of the compressed data can be improved.

The following describes in detail an implementation of matching an element in the first group of data with an element in the second group of data.

This embodiment of this application provides a solution of optimizing a matching relationship between two groups of elements, and an objective is to directly minimize a compressed codeword length.

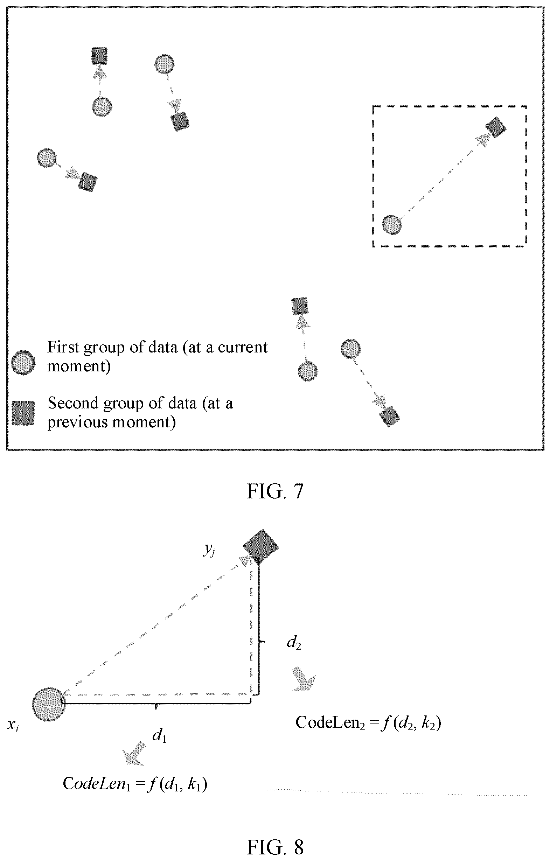

A specific solution is to use, as a loss function, a code length output by performing (parameterized) entropy encoding compression on a group of data to be output, and solve a matching optimization problem (that is, find an optimal matching differential manner) or a joint optimization problem of matching and entropy encoding parameters, that is, find an optimal entropy encoding parameter and an optimal matching differential manner at the same time, to achieve an optimal compression effect. The essence of matching is to find multiple pairing relationships between elements in two groups of data. As shown in FIG. 7 below, the first group of data is $\{x_1, x_2, \ldots, x_N\}$, and the second group of data is $\{y_1, y_2, \ldots, y_N\}$, where $x_i$ and $y_j$ are m-dimensional vectors, and m=2 is used as an example herein. The following uses an example in which each element in the first group of data and the second group of data includes a first-dimensional vector and a second-dimensional vector for description. For example, data in a first dimension is a horizontal angle of an angle of arrival, and data in a second dimension is a vertical angle of the angle of arrival. FIG. 7 is a diagram of matching an element in a first group of data with an element in a second group of data according to an embodiment of this application. As shown in FIG. 7, one circle corresponds to one element in the first group of data, and one square corresponds to one element in the second group of data. If there is a dashed arrow between a circle and a square, it indicates that an element corresponding to the circle is matched with an element corresponding to the square, the first group of data is a group of data that needs to be sent at a current moment, and the second group of data is a group of data that has been sent by a transmitter at a previous moment.

The foregoing matching optimization problem may be expressed as the following integer programming problem for solving:

$$\min_{\substack{k_1 \in \mathcal{K}_1, k_2 \in \mathcal{K}_2 \\ T \in \mathcal{R}^{N \times N}}} \sum_{ij} T_{ij} \boldsymbol{C_{ij}}(\boldsymbol{k_1}, \boldsymbol{k_2}) \quad (1)$$

A constraint condition is (subject to):

$$T_{ij} \in \{0,1\} \tag{2}$$

$$\sum_j T_{ij} = 1 \quad \forall i \in \{1,2,3,\dots N\} \tag{3}$$

$$\sum_i T_{ij} = 1 \quad \forall j \in \{1,2,3,\dots N\} \tag{4}$$

$\mathcal{K}_1$ represents an entropy encoding parameter set for the data in the first dimension, $\mathcal{K}_2$ represents an entropy encoding parameter set for the data in the second dimension, $k_1$ represents an entropy encoding parameter for the data in the first dimension, $k_2$ represents an entropy encoding parameter for the data in the second dimension, and $T_{ij}$ represents whether an $i^{th}$ element in the first group of data is matched with a $j^{th}$ element in the second group of data. $T_{ij}$ is 0 or 1. $T_{ij}$ is equal to 1, indicating that the $i^{th}$ element in the first group of data is matched with the $j^{th}$ element in the second group of data. $T_{ij}$ is equal to 0, indicating that the $i^{th}$ element in the first group of data is not matched with the $j^{th}$ element in the second group of data. Formula (3) indicates that for any element in the first group of data, only one element in the second group of data is matched with the any element. Formula (4) indicates that for any element in the second group of data, only one element in the first group of data is matched with the any element. Each of the first group of data and the second group of data includes N elements, where N is an integer greater than 1.

A loss function (cost) in the foregoing matching problem is $C_{i,j}(k_1, k_2) = f(d_1, k_1) + f(d_2, k_2)$, and $f(d_1, k_1)$ and $f(d_2, k_2)$ each represent a compressed output codeword length, as shown in FIG. 8 below. FIG. 8 is a diagram of a loss function calculation method for a matching optimization problem according to an embodiment of this application. As shown in FIG. 8, $d_1$ represents a horizontal coordinate difference between $\boldsymbol{x_i}$ and $\boldsymbol{y_j}$, and $d_2$ represents a vertical coordinate difference between $\boldsymbol{x_i}$ and $\boldsymbol{y_j}$. For $f(d_1, k_1)$ and $f(d_2, k_2)$, refer to Formula (5) below:

There are multiple loss function (matrix) calculation manners for the matching optimization problem based on different selected entropy encoding.

Manner 1: If a code length output by performing (parameterized) entropy encoding compression on a group of data to be output cannot be directly calculated, all possible pairings are actually compressed once, and an actual compression length is used as a loss function of the matching problem, for example, LZ encoding and arithmetic coding (without an entropy encoding parameter), and Huffman encoding (with an entropy encoding parameter).

Manner 2: If a code length output by performing (parameterized) entropy encoding compression on a group of data to be output may be directly calculated by using a formula, a calculation result of the formula is used as a loss function, for example, Golomb encoding (with an entropy encoding parameter).

For example, for Golomb encoding with a parameter of k, lossless compression is performed on a nonnegative integer d, and a formula for an output codeword length is:

$$f(d,k) = \left\lfloor \frac{d}{k} \right\rfloor + 1 + \lceil log_2 k \rceil \tag{5}$$

$\left\lfloor \frac{d}{k} \right\rfloor$ represents a floor operation on $\frac{d}{k}$, and $\lceil log_2 k \rceil$ represents a ceiling operation on $log_2 k$.

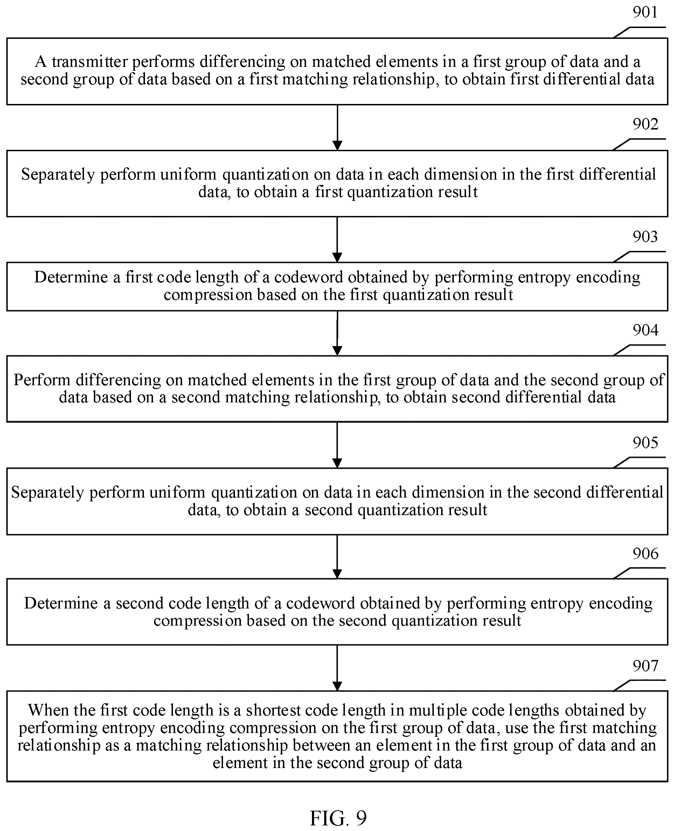

FIG. 9 is a flowchart of a method for matching an element in a first group of data with an element in a second group of data according to an embodiment of this application. As shown in FIG. 9, the method includes the following steps.

901: A transmitter performs differencing on matched elements in a first group of data and a second group of data based on a first matching relationship, to obtain first differential data.

The first matching relationship is an assumed matching relationship between an element in the first group of data and an element in the second group of data.

902: Separately perform uniform quantization on data in each dimension in the first differential data, to obtain a first quantization result.

903: Determine a first code length of a codeword obtained by performing entropy encoding compression based on the first quantization result.

A possible implementation of step 903 is as follows: Separately transform data in each dimension in the first quantization result into a nonnegative integer, to obtain a first transformation result; and determine the first code length of the codeword obtained by performing entropy encoding compression based on the first transformation result.

904: Perform differencing on matched elements in the first group of data and the second group of data based on a second matching relationship, to obtain second differential data.

The second matching relationship is an assumed matching relationship between an element in the first group of data and an element in the second group of data. The first matching relationship is different from the second matching relationship.

905: Separately perform uniform quantization on data in each dimension in the second differential data, to obtain a second quantization result.

906: Determine a second code length of a codeword obtained by performing entropy encoding compression based on the second quantization result.

A possible implementation of step 906 is as follows: Separately transform data in each dimension in the second quantization result into a nonnegative integer, to obtain a second transformation result; and determine the second code length of the codeword obtained by performing entropy encoding compression based on the second transformation result.

It should be noted that step 901 to step 903 may be understood as determining a code length output by performing differencing and entropy encoding compression on the first group of data based on the first matching relationship, and step 904 to step 906 may be understood as determining a code length output by performing differencing and entropy encoding compression on the first group of data based on the second matching relationship. Step 901 to step 903 and step 904 to step 906 are independent of each other, and an order is not limited. It should be understood that step 901 to step 903 and step 904 to step 906 are examples of determining a code length output by performing differencing and entropy encoding compression on the first group of data based on different matching relationships. In some embodiments, the transmitter may determine a code length output by performing differencing and entropy encoding compression on the first group of data based on all possible matching relationships, to find an optimal matching relationship, that is, a matching relationship enabling a shortest code length that is finally output.

907: When the first code length is a shortest code length in multiple code lengths obtained by performing entropy encoding compression on the first group of data, use the first matching relationship as a matching relationship between an element in the first group of data and an element in the second group of data.

The multiple code lengths include the first code length and the second code length. The first code length is a code length obtained by the transmitter by performing entropy encoding compression on the first group of data based on the first matching relationship, and the second code length is a code length obtained by the transmitter by performing entropy encoding compression on the first group of data based on the second matching relationship. The multiple code lengths may include code lengths output by the transmitter by performing differencing and entropy encoding compression on the first group of data based on all possible matching relationships. The first matching relationship may be considered as an optimal matching relationship. The method procedure in FIG. 9 is an example of the foregoing manner 1.

Step 907 may be replaced with: when the first code length is shorter than a preset code length, use the first matching relationship as a matching relationship between an element in the first group of data and an element in the second group of data. The preset code length may be set based on an actual requirement. This is not limited herein. In some embodiments, the transmitter sequentially determines code lengths output by performing differencing and entropy encoding compression on the first group of data based on multiple matching relationships; and when a code length output by performing differencing and entropy encoding compression on the first group of data based on a matching relationship is shorter than the preset code length, uses the matching relationship as a matching relationship between an element in the first group of data and an element in the second group of data. In this way, a workload can be reduced.

In this embodiment of this application, when the first code length is the shortest code length in the multiple code lengths obtained by performing entropy encoding compression on the first group of data, the first matching relationship is used as the matching relationship between the element in the first group of data and the element in the second group of data. Therefore, a compression effect can be improved.

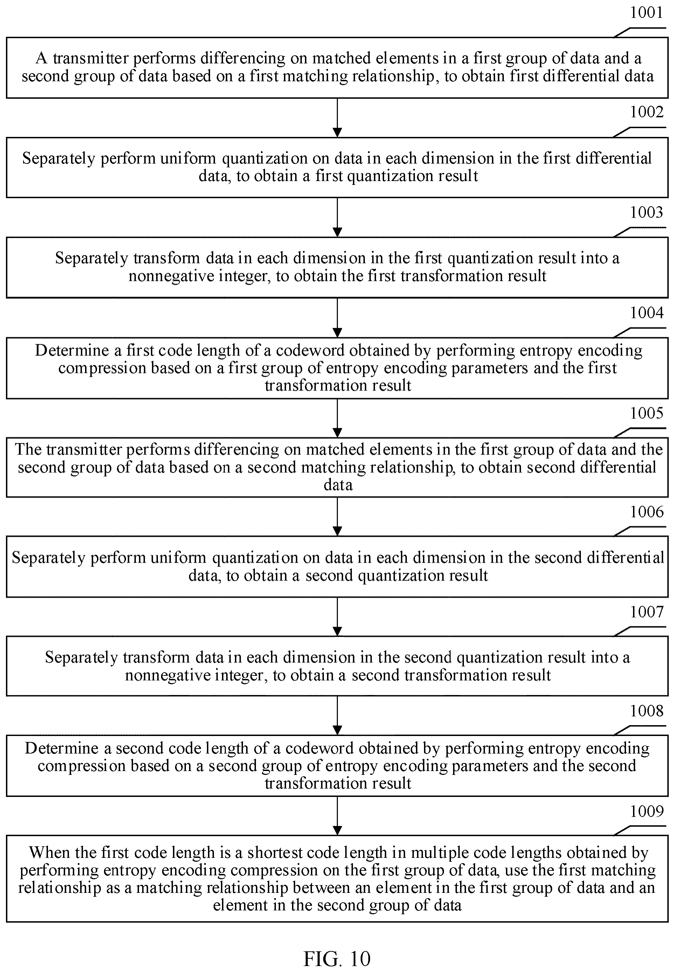

FIG. 10 is a flowchart of a method for matching an element in a first group of data with an element in a second group of data according to an embodiment of this application. As shown in FIG. 10, the method includes the following steps.

1001: A transmitter performs differencing on matched elements in a first group of data and a second group of data based on a first matching relationship, to obtain first differential data.

For step 1001, refer to step 901.

1002: Separately perform uniform quantization on data in each dimension in the first differential data, to obtain a first quantization result.

For step 1002, refer to step 902.

1003: Separately transform data in each dimension in the first quantization result into a nonnegative integer, to obtain a first transformation result.

1004: Determine a first code length of a codeword obtained by performing entropy encoding compression based on a first group of entropy encoding parameters and the first transformation result.

The first group of entropy encoding parameters is an assumed group of entropy encoding parameters.

1005: The transmitter performs differencing on matched elements in the first group of data and the second group of data based on a second matching relationship, to obtain second differential data.

1006: Separately perform uniform quantization on data in each dimension in the second differential data, to obtain a second quantization result.

1007: Separately transform data in each dimension in the second quantization result into a nonnegative integer, to obtain a second transformation result.

1008: Determine a second code length of a codeword obtained by performing entropy encoding compression based on a second group of entropy encoding parameters and the second transformation result.

The second group of entropy encoding parameters is another assumed group of entropy encoding parameters. The second group of entropy encoding parameters is different from the first group of entropy encoding parameters.

It should be noted that step 1001 to step 1004 may be understood as determining a code length output by performing differencing and entropy encoding compression on the first group of data based on the first matching relationship and the first group of entropy encoding parameters, and step 1005 to step 1008 may be understood as determining a code length output by performing differencing and entropy encoding compression on the first group of data based on the second matching relationship and the second group of entropy encoding parameters. Step 1001 to step 1004 and step 1005 to step 1008 are independent of each other, and an order is not limited. It should be understood that step 1001 to step 1004 and step 1005 to step 1008 are examples of determining a code length output by performing differencing and entropy encoding compression on the first group of data based on combinations of different matching relationships and entropy encoding parameters. In some embodiments, the transmitter may determine a code length output by performing differencing and entropy encoding compression on the first group of data based on combinations of all possible matching relationships and entropy encoding parameters, to find an optimal matching relationship and entropy encoding parameter, that is, a matching relationship and an entropy encoding parameter that enable a shortest code length that is finally output.

1009: When the first code length is a shortest code length in multiple code lengths obtained by performing entropy encoding compression on the first group of data, use the first matching relationship as a matching relationship between an element in the first group of data and an element in the second group of data.

The multiple code lengths include the first code length and the second code length. The first code length is a code length obtained by the transmitter by performing entropy encoding compression on the first group of data based on a combination of the first matching relationship and the first group of entropy encoding parameters, and the second code length is a code length obtained by the transmitter by performing entropy encoding compression on the first group of data based on a combination of the second matching relationship and the second group of entropy encoding parameters. The multiple code lengths may include code lengths output by the transmitter by performing differencing and entropy encoding compression on the first group of data based on combinations of all possible matching relationships and entropy encoding parameters. The first matching relationship may be considered as an optimal matching relationship, and the first group of entropy encoding parameters may be considered as an optimal group of entropy encoding parameters. The method procedure in FIG. 10 is an example of the foregoing manner 2. The method procedure in FIG. 10 is a procedure of jointly optimizing the matching relationship and the entropy encoding parameter, that is, finding an optimal entropy encoding parameter and an optimal matching differential manner.

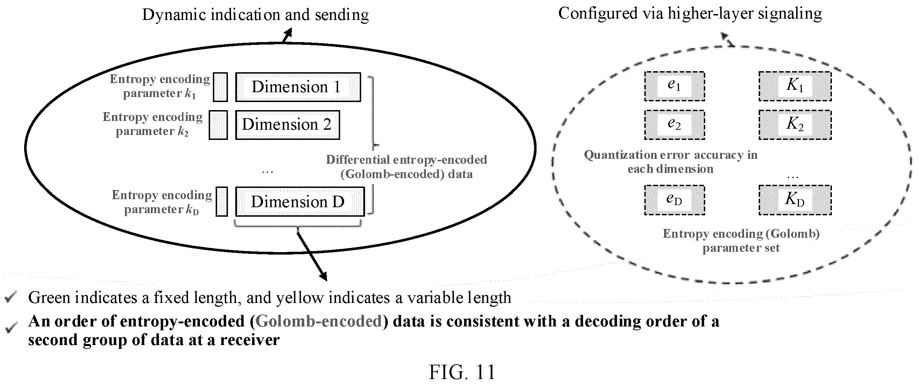

The transmitter may further perform the following operation: using the first group of entropy encoding parameters as entropy encoding parameters to be used for performing entropy encoding compression on the first group of data. The performing entropy encoding compression based on the first quantization result, to obtain the compressed data in the method procedure in FIG. 6 may be: separately transforming the data in each dimension in the first quantization result into the nonnegative integer, to obtain the first transformation result; and separately performing entropy encoding compression on data in a corresponding dimension in the first transformation result by using an entropy encoding parameter in each dimension in the first group of entropy encoding parameters, to obtain the compressed data, where the compressed data includes first indication information, and the first indication information indicates the first group of entropy encoding parameters. The first indication information indicates an entropy encoding parameter of data in each dimension, that is, the first group of entropy encoding parameters. It should be understood that the transmitter may dynamically indicate the entropy encoding parameter of the data in each dimension. For example, the entropy encoding parameter of the data in each dimension is represented by a subscript for a selected parameter in an encoding parameter set configured by the transmitter. FIG. 11 shows an example of content exchanged between a transmitter and a receiver according to an embodiment of this application. As shown in FIG. 11, the transmitter dynamically indicates an entropy encoding parameter of data in each dimension, that is, $k_1$, $k_2$, ..., and $k_D$, dimension 1, dimension 2, ..., and dimension D represent entropy-encoded data of data in D different dimensions, $e_1$, $e_2$, ..., $e_D$ represent quantization error accuracy of the data in the D different dimensions, $\mathcal{K}_1$, $\mathcal{K}_2$ ..., $\mathcal{K}_D$ represent an entropy encoding parameter set of the data in the D different dimensions. An order of entropy-encoded data in compressed data sent by the transmitter (or an order of performing entropy encoding compression on differential values in differential data) is consistent with a decoding order of elements in a second group of data at the receiver. D is an integer greater than 1. In some embodiments, a core network may configure quantization error accuracy and an entropy encoding parameter set in each dimension for the transmitter and the receiver by using higher layer signaling.

Step 1009 may be replaced with: when the first code length is shorter than a preset code length, use the first matching relationship as a matching relationship between an element in the first group of data and an element in the second group of data. The preset code length may be set based on an actual requirement. This is not limited herein. In some embodiments, the transmitter sequentially determines code lengths output by performing differencing and entropy encoding compression on the first group of data based on combinations of multiple matching relationships and entropy encoding parameters; and when a code length output by performing differencing and entropy encoding compression on the first group of data based on a combination of a matching relationship and an entropy encoding parameter is shorter than the preset code length, uses the matching relationship as a matching relationship between an element in the first group of data and an element in the second group of data. In this way, a workload can be reduced.

In this embodiment of this application, when the first code length is the shortest code length in the multiple code lengths obtained by performing entropy encoding compression on the first group of data, the first matching relationship is used as the matching relationship between the element in the first group of data and the element in the second group of data. Therefore, a compression effect can be improved.

The manner of matching the element in the first group of data with the element in the second group of data provided in this embodiment of this application is applicable to a case in which a quantity of elements in the first group of data is equal to a quantity of elements in the second group of data, and is also applicable to a case in which a quantity of elements in the first group of data is not equal to a quantity of elements in the second group of data.

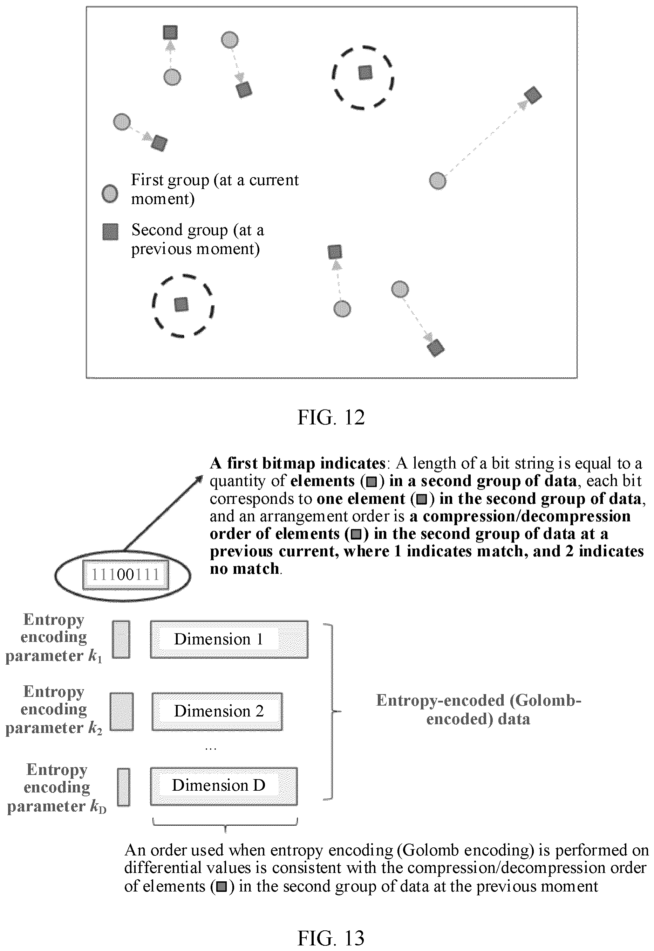

When the quantity of elements in the first group of data (at a current moment) is less than the quantity of elements in the second group of data (at a previous moment), because some elements belonging to the second group of data are not matched with the elements in the first group of data (as shown in FIG. 12), a first bitmap (bitmap) needs to be further introduced to indicate specific elements in the second group of data that are matched with the elements in the first group of data (as shown in FIG. 13). Joint optimization can solve an original matching problem by slightly changing the original matching problem (adding a virtual element).

The integer programming problem of Formula (1) is applicable to a case in which quantities of elements in two groups of data are equal (both are N). For a case in which quantities of elements in two groups of data are not equal, it may be assumed that the first group of data has M elements, and the second group of data has N elements ($M<N$). In this case, ($N-M$) dumb elements may be added to the elements in the first group of data, and subscripts $i$ of the ($N-M$) dumb elements are denoted as ($M+1$), ($M+2$), ..., and ($N-M$) respectively. In the original problem (1), values of $C_{ij}$ corresponding to these dumb elements are all set to large values (assuming that a largest value in values of $C_{ij}$ corresponding to subscripts of non-dumb elements is denoted as Max, $C_{ij}$

corresponding to these dumb elements is not less than Max*($M+N$)). Then, the integer programming problem corresponding to Formula (1) is solved to obtain a matching relationship $T_{ij}$. In the last step, all values of $T_{ij}$ ($M+1 \leq i \leq N - M$) corresponding to the subscripts of the dumb elements are deleted, to obtain $T_{ij}$ corresponding to only $i \leq M$ original elements in the first group of data. Then, a specific element in the second group of data that is matched with each element in the first group of data and specific elements in the second group of data that are not matched can be determined based on these values of $T_{ij}$.

FIG. 12 is a diagram of matching when a quantity of elements in a first group of data is less than a quantity of elements in a second group of data according to an embodiment of this application. As shown in FIG. 12, one circle represents one element in the first group of data, one square represents one element in the second group of data, six elements in the first group of data are matched with six elements in the second group of data, and two elements in the second group of data are not matched with the elements in the first group of data. FIG. 13 is a diagram of content in compressed data according to an embodiment of this application. As shown in FIG. 13, the compressed data includes a first bitmap (Bitmap), first indication information (optional), and entropy-encoded data. The first indication information indicates entropy encoding parameters of data in D dimensions, that is, $k_1$, $k_2$, ..., and $k_D$, dimension 1, dimension 2, ..., and dimension D represent entropy-encoded data of the data in the D different dimensions, and an order of the entropy-encoded data in the compressed data (or an order used when entropy encoding compression is performed on differential values in differential data) is consistent with a decoding order of elements in a second group of data at a receiver. The first bitmap is 11100111, and the second group of data includes six elements. A length of a bit string (six bits) in the first bitmap is equal to a quantity of elements in the second group of data. One bit in the first bitmap corresponds to one element in the second group of data. An arrangement order of elements corresponding to bits in the first bitmap is the same as a compression encoding or decoding order of elements in the second group of data. When a bit in the first bitmap is 1, an element corresponding to the bit is matched with an element in the first group of data. When a bit in the first bitmap is 0, an element corresponding to the bit is not matched with an element in a first group of data. In this application, the order of the entropy-encoded data in the compressed data may be an order used when entropy encoding compression is performed on elements (or differential values) in differential data (for example, first differential data).

When a quantity of elements in the first group of data (at a current moment) is less than a quantity of elements in the second group of data (at a previous moment), the receiver first decodes an entropy encoding parameter in each dimension, decodes (row by row) differential data in each dimension based on the entropy encoding parameter, and then adds (column by column) differential values and corresponding elements in the second group of data based on the first bitmap to restore the elements in the first group of data at the current moment.

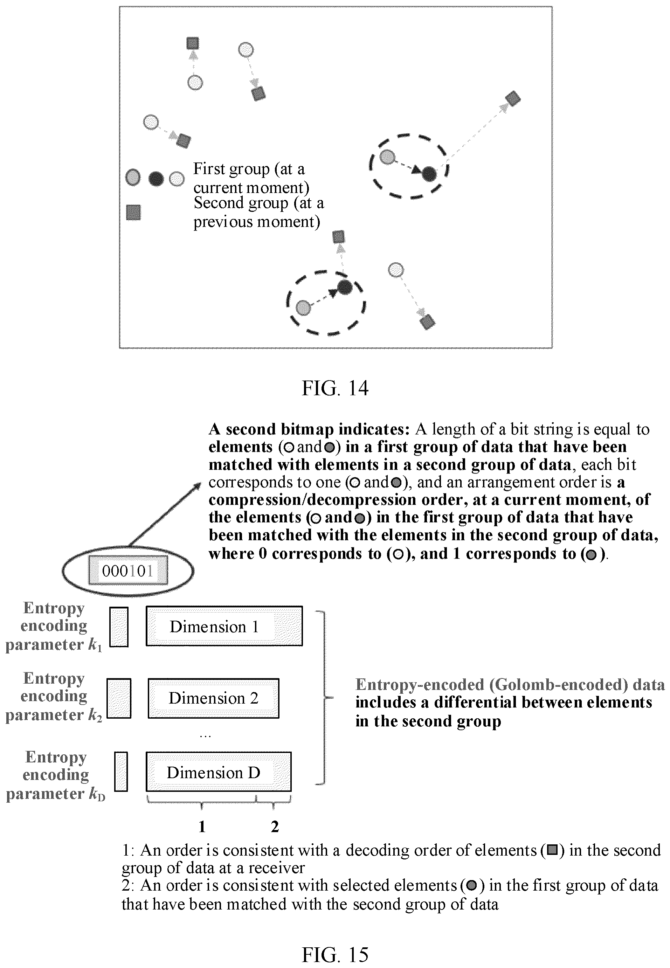

When a quantity of elements in the first group of data (at a current moment) is greater than a quantity of elements in the second group of data (at a previous moment), if the foregoing matching solution is used, some elements in the first group of data are excessive, as shown in FIG. 14. FIG. 14 is a diagram of matching when a quantity of elements in a first group of data is greater than a quantity of elements in a second group of data according to an embodiment of this application. As shown in FIG. 14, one circle represents one element in the first group of data, one square represents one element in the second group of data, the first group of data includes eight elements in total, six elements in the first group of data are matched with elements in the second group of data, and two elements in the first group of data are not matched with elements in the second group of data. Because some remaining elements in the first group of data are not paired with the elements in the second group of data, in this embodiment of this application, the transmitter may use the paired elements in the first group of data as a reference for performing differencing. In this case, a second bitmap (bitmap) indicates a pairing relationship between an unpaired element in the first group of data and a paired element in the first group of data (as shown in FIG. 15). The elements in the first group of data are classified into a first part of elements and a second part of elements. The first part of elements are an element that is in the first group of data and that is not matched with an element in the second group of data, and the second part of elements are an element that is in the first group of data and that is matched with an element in the second group of data. One bit in the second bitmap corresponds to one element in the second part of elements. A length of a bit string in the second bitmap is equal to a quantity of elements in the second part of elements. The second bitmap indicates whether the element in the second part of elements is matched with the element in the first part of elements.

FIG. 15 is a diagram of content in compressed data according to an embodiment of this application. As shown in FIG. 15, the compressed data includes a second bitmap (Bitmap), first indication information (optional), and entropy-encoded data. The first indication information indicates entropy encoding parameters of data in D dimensions, that is, $k_1$, $k_2$, ..., and $k_D$, and dimension 1, dimension 2, ..., and dimension D represent entropy-encoded data of the data in the D different dimensions. An order of a part of entropy-encoded data (first compressed sub-data, that is, entropy-encoded data indicated by 1 in FIG. 15) in the compressed data is consistent with a decoding order of elements in a second group of data at a receiver, and an order of another part of entropy-encoded data (second compressed sub-data, that is, entropy-encoded data indicated by 2 in FIG. 15) in the compressed data is consistent with a decoding order, at the receiver, of selected elements in a first group of data that have been matched with the elements in the second group of data. The second bitmap is 000101, a quantity of elements that are in the first group of data and that are matched with the elements in the second group of data is 6, a length of a bit string in the second bitmap is equal to the quantity of elements that are in the first group of data and that are matched with the elements in the second group of data, one bit in the second bitmap corresponds to one element in a second part of elements, an arrangement order of elements corresponding to bits in the second bitmap is the same as a compression, encoding or decoding order of elements in the second part of elements, and the second bitmap indicates that a 4th element and a 6th element that are arranged in the compression encoding or decoding order in the second part of elements are matched with elements in a first part of elements.

The receiver may first decode an entropy encoding parameter in each dimension, decode (row by row) differential data in each dimension based on the entropy encoding parameter, then decode (column by column) elements in the first group of data that are matched with elements in the second group of data, for example, add differential data obtained by decoding the first compressed sub-data to corresponding elements in the second group of data, and finally decode an element in the first group of data that is not matched with the element in the second group of data, for example, add an element in differential data obtained by decoding the second compressed sub-data to a decoded element that is selected as a reference in the first group of data, or add an element in differential data obtained by decoding the second compressed sub-data to a reference element corresponding to each element. The receiver may determine, based on the second bitmap, the reference element corresponding to each element in the differential data obtained by decoding the second compressed sub-data. An example of a decoding procedure of the receiver is as follows: The elements in the second group of data are B2, B3, B4, B1, B5 and B6 sequentially in the decoding order, and the second bitmap in the compressed data is 000101. The receiver first decodes an entropy encoding parameter in each dimension in the compressed data; decodes (row by row) differential data in each dimension based on the entropy encoding parameter in each dimension to obtain first differential data, where elements in the first differential data are C2, C3, C4, C1, C5, C6, C7 and C8 sequentially in the decoding order; add elements that are in the first differential data and that are matched with the elements in the second group of data to corresponding parameter elements, to obtain a first part of elements, where elements in the first part of elements are A2, A3, A4, A1, A5 and A6 sequentially in the decoding order, C2 and B2 are added to obtain the element A2, C3 and B3 are added to obtain the element A3, C4 and B4 are added to obtain the element A4, C1 and B1 are added to obtain the elementA1, C5 and B5 are added to obtain the element A5, and C6 and B6 are added to obtain the element A6; and add, based on the second bitmap, elements that are in the first differential data and that are not matched with the elements in the second group of data to corresponding parameter elements, to obtain a second part of elements, where elements in the second part of elements are A7 and A8 sequentially in the decoding order, C7 and A4 are added to obtain A7, and C8 and A6 are added to obtain A8.

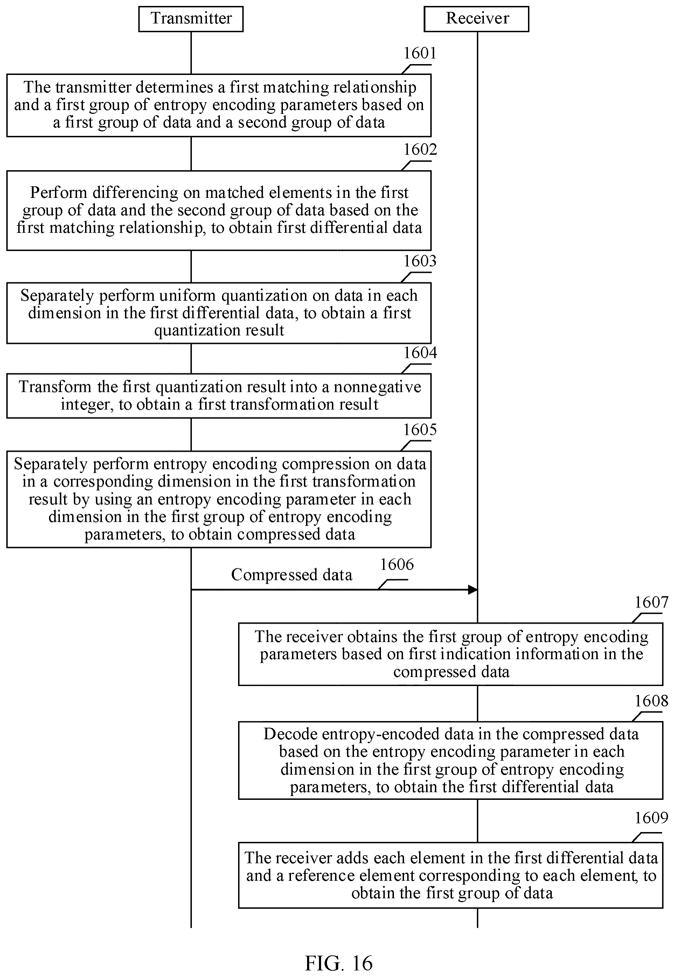

FIG. 16 is a flowchart of a data compression method according to an embodiment of this application. As shown in FIG. 16, the method includes the following steps.

1601: A transmitter determines a first matching relationship and a first group of entropy encoding parameters based on a first group of data and a second group of data.

For example, the first matching relationship and the first group of entropy encoding parameters are an optimal entropy encoding parameter (that is, the first group of entropy encoding parameters) and an optimal matching differential manner, that is, the first matching relationship, obtained by the transmitter by performing the procedure of jointly optimizing the matching relationship and the entropy encoding parameters in FIG. 10. For another example, the first matching relationship and the first group of entropy encoding parameters are a combination of a better matching relationship and better entropy encoding parameters obtained by the transmitter by performing the procedure of jointly optimizing the matching relationship and the entropy encoding parameters in FIG. 10, that is, a combination of the first group of entropy encoding parameters and the first matching relationship. The transmitter may alternatively jointly optimize the matching relationship and the entropy encoding parameters in another manner. This is not limited in this application.

1602: Perform differencing on matched elements in the first group of data and the second group of data based on the first matching relationship, to obtain first differential data.

For step 1602, refer to step 602.

1603: Separately perform uniform quantization on data in each dimension in the first differential data, to obtain a first quantization result.

For step 1603, refer to step 603.

1604: Transform the first quantization result into a nonnegative integer, to obtain a first transformation result.

1605: Separately perform entropy encoding compression on data in a corresponding dimension in the first transformation result by using an entropy encoding parameter in each dimension in the first group of entropy encoding parameters, to obtain compressed data.

The compressed data includes first indication information, and the first indication information indicates the first group of entropy encoding parameters.

1606: The transmitter sends the compressed data to a receiver.

Correspondingly, the receiver receives the compressed data from the transmitter.

1607: The receiver obtains the first group of entropy encoding parameters based on the first indication information in the compressed data.

1608: The receiver decodes entropy-encoded data in the compressed data based on an entropy encoding parameter in each dimension in the first group of entropy encoding parameters, to obtain the first differential data.

1609: The receiver adds each element in the first differential data and a reference element corresponding to each element, to obtain the first group of data.

For step 1609, refer to step 607. The method procedure in FIG. 16 is applicable to a scenario in which a quantity of elements in the first group of data is less than or equal to a quantity of elements in the second group of data. When the quantity of elements in the first group of data is equal to the quantity of elements in the second group of data, the transmitter and the receiver may implement compression and transmission of the first group of data by using the method procedure in FIG. 16.

When the quantity of elements in the first group of data is less than the quantity of elements in the second group of data, the compressed data includes a first bitmap, where one bit in the first bitmap corresponds to one element in the second group of data, and the first bitmap indicates whether the element in the second group of data is matched with the element in the first group of data. Based on the method procedure in FIG. 16, before performing step 1609, the transmitter determines, based on the first bitmap, the reference element corresponding to each element in the first differential data. Optionally, an arrangement order of elements corresponding to bits in the first bitmap is the same as a compression encoding or decoding order of elements in the second group of data. For example, the first group of data includes six elements, the second group of data includes eight elements, and the first bitmap is 11100111. An arrangement order of elements corresponding to bits in the first bitmap is the same as a compression encoding or decoding order of elements in the second group of data. An order of elements in the first differential data corresponds to a decoding order of elements in the second group of data at the receiver. An element corresponding to a bit whose bit value is 1 in the first bitmap is matched with an element in the first group of data, and an element corresponding to a bit whose bit value is 0 in the first bitmap is not matched with an element in the first group of data. The transmitter determines, based on the first bitmap, that a reference element of a 1st element in the decoding order in the first differential data is a 1st

element in the decoding order in the second group of data, a reference element of a 2nd element in the decoding order in the first differential data is a 2nd element in the decoding order in the second group of data, a reference element of a 3rd element in the decoding order in the first differential data is a 3rd element in the decoding order in the second group of data, a reference element of a 4th element in the decoding order in the first differential data is a 6th element in the decoding order in the second group of data, a reference element of a 5th element in the decoding order in the first differential data is a 7th element in the decoding order in the second group of data, and a reference element of a 6th element in the decoding order in the first differential data is an 8th element in the decoding order in the second group of data.

In this embodiment of this application, the matching relationship and the entropy encoding parameters are jointly optimized, so that compression performance can be improved. Uniform quantization is separately performed on data in each dimension in the first differential data, to obtain the first quantization result, so that absolute accuracy of the compressed data can be improved.

In some embodiments, the transmitter may use multiple groups of data as a matching reference, to find a better compression result. The following uses an example in which the transmitter is allowed to use two groups of data as a reference. The solutions in embodiments of this application are not limited thereto.

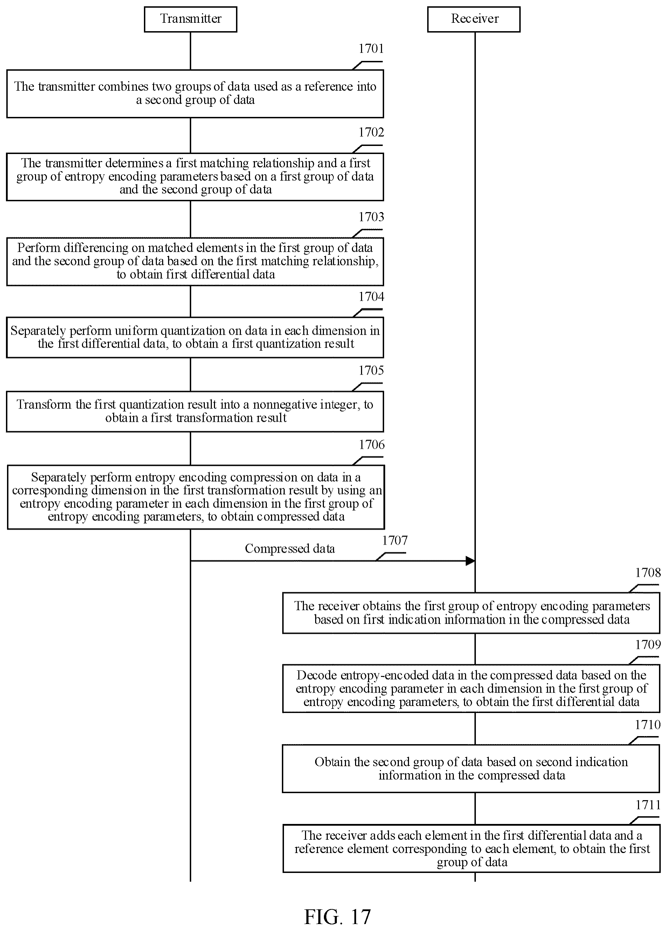

FIG. 17 is a flowchart of a data compression method according to an embodiment of this application. As shown in FIG. 17, the method includes the following steps.

1701: A transmitter combines two groups of data used as a reference into a second group of data.

The two groups of data used by the transmitter as the reference are data that is sent by the transmitter to a receiver at different moments and that is successfully received by the receiver. For example, one group of data used by the transmitter as a reference is a group of data $\{y_1, y_2, ..., y_{N_2}\}$ that has been sent by the transmitter to the receiver at a previous moment and that is successfully received by the receiver, and the other group of data is a group of data $\{z_1, z_2, ..., z_{N_3}\}$ that has been sent by the transmitter to the receiver at a previous moment of the previous moment and that is successfully received by the receiver. The transmitter may combine $\{y_1, y_2, ..., y_{N_2}\}$ and $\{z_1, z_2, ..., z_{N_3}\}$ into a new group of data $\{y_1, y_2, ..., y_{N_2}, z_1, z_2, ..., z_{N_3}\}$, that is, the second group of data.

1702: The transmitter determines a first matching relationship and a first group of entropy encoding parameters based on a first group of data and the second group of data.

For step 1702, refer to step 1601.

1703: Perform differencing on matched elements in the first group of data and the second group of data based on the first matching relationship, to obtain first differential data.

For step 1703, refer to step 602.

1704: Separately perform uniform quantization on data in each dimension in the first differential data, to obtain a first quantization result.

For step 1704, refer to step 603.

1705: Transform the first quantization result into a nonnegative integer, to obtain a first transformation result.

1706: Separately perform entropy encoding compression on data in a corresponding dimension in the first transformation result by using an entropy encoding parameter in each dimension in the first group of entropy encoding parameters, to obtain compressed data.

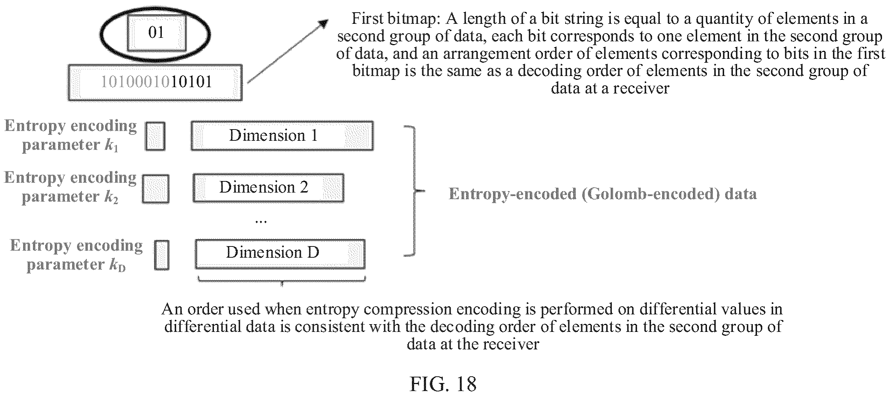

The compressed data includes first indication information and second indication information. The first indication information indicates the first group of entropy encoding parameters. The second indication information indicates a quantity of data groups referenced for sending the first group of data by the transmitter, that is, a quantity of third data groups. The transmitter and the receiver may first configure a set $\mathcal{N}$ of quantities that can be selected, and then use the second indication information (for example, a subscript) to indicate a selected quantity. For example, $\mathcal{N} = \{1, 2, 3, 4\}$. 00 (the second indication information) represents 1, 01 represents 2, 10 represents 3, and 11 represents 4, which are agreed on by the transmitter and the receiver. The transmitter and the receiver may agree that the quantity indicated by the second indication information is a quantity of data groups that are recently successfully received by the receiver from the transmitter. The receiver may first determine, based on the second indication information, the quantity of data groups referenced for the first group of data, and then obtain the second group of data. FIG. 18 shows an example of content in compressed data according to an embodiment of this application. As shown in FIG. 18, the compressed data includes a first bitmap (Bitmap), first indication information, second indication information, and entropy-encoded data. The first bitmap is 1010001010101. A length of a bit string (13 bits) in the first bitmap is equal to a quantity of elements in the second group of data. One bit in the first bitmap corresponds to one element in the second group of data. An arrangement order of elements corresponding to bits in the first bitmap is the same as a decoding order of elements in the second group of data at the receiver. The first indication information indicates entropy encoding parameters of data in D dimensions, that is, $k_1, k_2, ...,$ and $k_D$, dimension 1, dimension 2, ..., and dimension D represent entropy-encoded data of the data in the D different dimensions, and the second indication information is 01. An order of the entropy-encoded data in the compressed data (or an order used when entropy encoding compression is performed on differential values in differential data) is consistent with the decoding order of elements in the second group of data at the receiver.

1707: The transmitter sends the compressed data to the receiver.

Correspondingly, the receiver receives the compressed data from the transmitter.

1708: The receiver obtains the first group of entropy encoding parameters based on the first indication information in the compressed data.

1709: The receiver decodes entropy-encoded data in the compressed data based on an entropy encoding parameter in each dimension in the first group of entropy encoding parameters, to obtain the first differential data.

1710: The receiver obtains the second group of data based on the second indication information in the compressed data.

An order of step 1701, step 1708, and step 1709 is not limited. For example, the first indication information in the compressed data indicates that the quantity of data groups referenced for sending the first group of data by the transmitter is 2, and the receiver combines two groups of data that are recently successfully received twice from the transmitter, that is, $\{y_1, y_2, \ldots, y_{N_2}\}$ and $\{z_1, z_2, \ldots, z_{N_3}\}$, to obtain the second group of data, that is, $\{y_1, y_2, \ldots, y_{N_2}, z_1, z_2, \ldots, z_{N_3}\}$.

1711: The receiver adds each element in the first differential data and a reference element corresponding to each element, to obtain the first group of data.

For step 1711, refer to step 607.

In this embodiment of this application, the transmitter uses multiple groups of data as a matching reference, to find a better compression result.

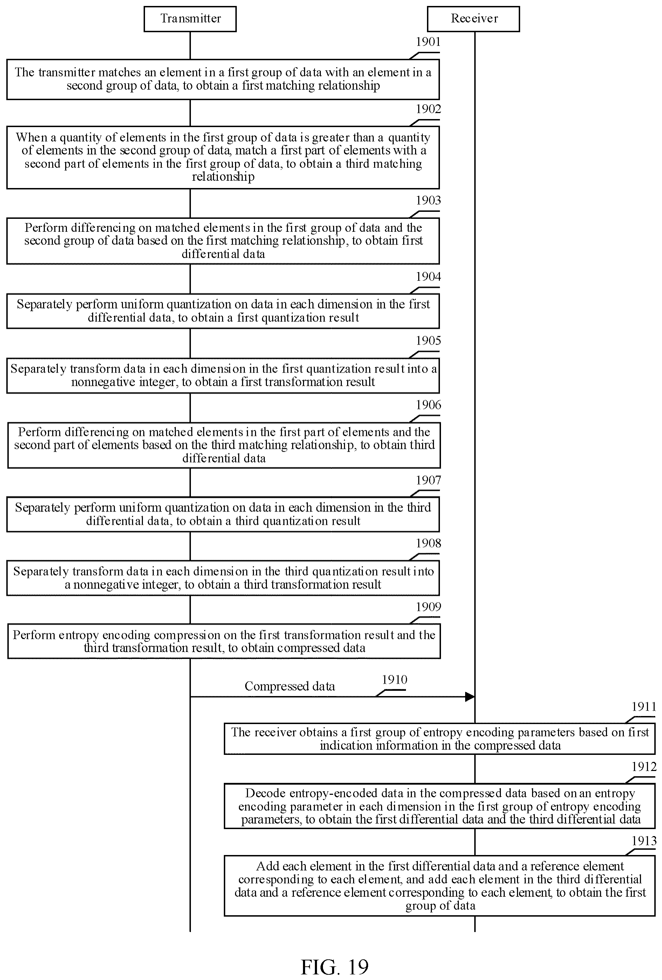

FIG. 19 is a flowchart of another data compression method according to an embodiment of this application. The method procedure in FIG. 19 is applicable to a scenario in which a quantity of elements in a first group of data (at a current moment) is greater than a quantity of elements in a second group of data (at a previous moment). As shown in FIG. 19, the method includes the following steps.

1901: A transmitter matches an element in a first group of data with an element in a second group of data, to obtain a first matching relationship.

For step 1901, refer to step 601. For example, elements in the second group of data are B2, B3, B4, B1, B5 and B6 sequentially in a decoding order, the first group of data includes A1, A2, A3, A4, A5, A6, A7 and A8, and the first matching relationship includes: A1 is matched (or paired) with B1, A2 is matched with B2, A3 is matched with B3, A4 is matched with B4, A5 is matched with B5, and A6 is matched with B6.

1902: When a quantity of elements in the first group of data is greater than a quantity of elements in the second group of data, match a first part of elements in the first group of data with a second part of elements, to obtain a third matching relationship.

The first part of elements are an element that is in the first group of data and that is not matched with an element in the second group of data. The second part of elements are an element that is in the first group of data and that is matched with an element in the second group of data. For example, elements in the second group of data are B2, B3, B4, B1, B5 and B6 sequentially in a decoding order, the first group of data includes A1, A2, A3, A4, A5, A6, A7 and A8, and the first matching relationship includes: A1 is matched (or paired) with B1, A2 is matched with B2, A3 is matched with B3, A4 is matched with B4, A5 is matched with B5, and A6 is matched with B6. The first part of elements in the first group of data include A7 and A8. The second part of elements include A1, A2, A3, A4, A5 and A6, and the third matching relationship includes: A7 is matched with A1, and A8 is matched with A6.

1903: Perform differencing on matched elements in the first group of data and the second group of data based on the first matching relationship, to obtain first differential data.

Each element in the first differential data corresponds to one element in the second group of data, and a reference element of any element in the first differential data is an element corresponding to the any element in the second group of data. For example, the first matching relationship includes: A1 is matched (or paired) with B1, A2 is matched with B2, A3 is matched with B3, A4 is matched with B4, A5 is matched with B5, and A6 is matched with B6; and an example of performing differencing on matched elements in the first group of data and the second group of data based on the first matching relationship is as follows: A1 minus B1 obtains C1, A2 minus B2 obtains C2, A3 minus B3 obtains C3, A4 minus B4 obtains C4, A5 minus B5 obtains C5, and A6 minus B6 obtains C6. The first differential data includes C1, C2, C3, C4, C5 and C6.

1904: Separately perform uniform quantization on data in each dimension in the first differential data, to obtain a first quantization result.

For example, the first differential data includes C1, C2, C3, C4, C5 and C6, and the first quantization result includes D1, D2, D3, D4, D5 and D6. D1 is obtained by performing uniform quantization on C1, D2 is obtained by performing uniform quantization on C2, D3 is obtained by performing uniform quantization on C3, D4 is obtained by performing uniform quantization on C4, D5 is obtained by performing uniform quantization on C5, and D6 is obtained by performing uniform quantization on C6.

1905: Separately transform data in each dimension in the first quantization result into a nonnegative integer, to obtain a first transformation result.

For example, the first quantization result includes D1, D2, D3, D4, D5 and D6, and the first transformation result includes E1, E2, E3, E4, E5 and E6. E1 is obtained by separately transforming data in each dimension in D1 into a nonnegative integer, E2 is obtained by separately transforming data in each dimension in D2 into a nonnegative integer, ..., and E6 is obtained by separately transforming data in each dimension in D6 into a nonnegative integer.

1906: Perform differencing on matched elements in the first part of elements and the second part of elements based on the third matching relationship, to obtain third differential data.

For example, the third matching relationship includes: A7 is matched with A4, and A8 is matched with A6; and the performing differencing on matched elements in the first part of elements and the second part of elements based on the third matching relationship is: A7 minus A4 obtains C7, and A8 minus A6 obtains C8. The third differential data includes C7 and C8.

1907: Separately perform uniform quantization on data in each dimension in the third differential data, to obtain a third quantization result.

For example, the third differential data includes C7 and C8, and the third quantization result includes D7 and D8. D7 is obtained by performing uniform quantization on C7, and D8 is obtained by performing uniform quantization on C8.

1908: Separately transform data in each dimension in the third quantization result into a nonnegative integer, to obtain a third transformation result.

For example, the third quantization result includes D7 and D8, and the third transformation result includes E7 and E8. E7 is obtained by separately transforming data in each dimension in D7 into a nonnegative integer, and E8 is obtained by separately transforming data in each dimension in D8 into a nonnegative integer.

1909: Perform entropy encoding compression on the first transformation result and the third transformation result, to obtain compressed data.

A possible implementation of step 1909 is as follows: separately performing entropy encoding compression on data in a corresponding dimension in the first transformation result and the third transformation result by using an entropy encoding parameter in each dimension in a first group of entropy encoding parameters, to obtain the compressed data. The compressed data includes first indication information, and the first indication information indicates the first group of entropy encoding parameters.

That the transmitter performs entropy encoding compression on the first transformation result may be: sequentially performing entropy encoding compression on elements in the first transformation result in a compression or decompression order of elements, in the second group of data, corresponding to the elements in the first transformation result. For example, the first transformation result includes E1, E2, E3, E4, E5 and E6, and the elements in the second group of data are B2, B3, B4, B1, B5, and B6 sequentially in the decoding order. E1 corresponds to B1, E2 corresponds to B2, E3 corresponds to B3, E4 corresponds to B4, E5 corresponds to B5, and E6 corresponds to B6. The transmitter performs entropy encoding compression on E2, E3, E4, E1, E5 and E6 sequentially. That the transmitter performs entropy encoding compression on the third transformation result may be: sequentially performing entropy encoding compression on elements in the third transformation result in a compression or decompression order of elements, in the second part of elements, corresponding to the elements in the third transformation result. For example, the third transformation result includes E7 and E8. E7 corresponds to A1, and E8 corresponds to A6. Because A1 is compressed before A6, the transmitter first performs entropy encoding compression on E7, and then performs entropy encoding compression on E8. Entropy-encoded data in the compressed data is F2, F3, F4, F1, F5, F6, F7, and F8 sequentially in the decoding order. F2 is obtained by performing entropy encoding compression on E2, F3 is obtained by performing entropy encoding compression on E3, ..., and F8 is obtained by performing entropy encoding compression on E8.

1910: The transmitter sends the compressed data to the receiver.

Correspondingly, the receiver receives the compressed data from the transmitter.

1911: The receiver obtains the first group of entropy encoding parameters based on the first indication information in the compressed data.

1912: The receiver decodes the entropy-encoded data in the compressed data based on the entropy encoding parameter in each dimension in the first group of entropy encoding parameters, to obtain the first differential data and the third differential data.

Step 1911 and step 1912 may be replaced with: decoding the compressed data, to obtain the first differential data and the third differential data. The first indication information in the compressed data is optional. For example, the transmitter may perform entropy encoding compression on the first transformation result and the third transformation result by using LZ encoding or arithmetic coding.

For example, the entropy-encoded data in the compressed data is F2, F3, F4, F1, F5, F6, F7 and F8 sequentially in the decoding order, elements in the first differential data are C2, C3, C4, C1, C5 and C6 sequentially in the decoding order, and elements in the third differential data are C7 and C8 sequentially in the decoding order.

1913: Add each element in the first differential data and the reference element corresponding to each element, and add each element in the third differential data and a reference element corresponding to each element, to obtain the first group of data.

Each element in the first differential data corresponds to one element in the second group of data, and a reference element of any element in the first differential data is an element corresponding to the any element in the second group of data. Each element in the third differential data corresponds to one element in the first differential data. The compressed data includes a second bitmap, and one bit in the second bitmap corresponds to one element in the first differential data. The second bitmap indicates whether an element in the first differential data is matched with an element in the third differential data. For example, the second bitmap is 000101, and the second bitmap indicates that a $4^{th}$ element and a $6^{th}$ element in the first differential data in the decoding order are matched with elements in the third differential data, and other elements are not matched with elements in the third differential data. For another example, the second bitmap is 000101, elements in the third differential data are C7 and C8 sequentially in the decoding order, C7 corresponds to a $4^{th}$ element that is in the first differential data and that is arranged in the decoding order, and C8 corresponds to a $6^{th}$ element that is in the first differential data and that is arranged in the decoding order. A reference element corresponding to a second element in the third differential data is a sum of a third element that is in the first differential data and that corresponds to the second element and a reference element corresponding to the third element. The second element is any element in the third differential data. For example, elements in the first differential data are C2, C3, C4, C1, C5 and C6 sequentially in the decoding order, elements in the third differential data are C7 and C8 sequentially in the decoding order, and the second bitmap is 000101. Elements in the second group of data are B2, B3, B4, B1, B5, and B6 sequentially in the decoding order, C2 corresponds to B2, C3 corresponds to B3, C4 corresponds to B4, C1 corresponds to B1, C5 corresponds to B5, C6 corresponds to B6, C7 corresponds to C1, and C8 corresponds to C6. The adding each element in the first differential data and the reference element corresponding to each element includes: adding C2 and B2 to obtain A2, adding C3 and B3 to obtain A3, adding C4 and B4 to obtain A4, adding C1 and B1 to obtain A1, adding C5 and B5 to obtain A5, adding C6 and B6 to obtain A6, adding C7 and A1 to obtain A7, and adding C8 and A6 to obtain A8. The first group of data is A2, A3, A4, A1, A5, A6, A7 and A8 sequentially in the decoding order.

In this embodiment of this application, each element in the third differential data is added to the reference element corresponding to each element, to obtain, through decoding, the first group of data that includes elements more than elements in the second group of data that is used as reference data.

In this embodiment of this application, a necessary condition for successful decoding at the receiver is that Tx and Rx (that is, the transmitter and the receiver) use same reference data. Due to a transmission error, the receiver may fail to decode a group of data, and the transmitter needs to know this event. Therefore, feedback signaling needs to be introduced. The receiver feeds back a decoding result of the group of data based on whether decoding is successful. This embodiment of this application describes two working modes in which feedback signaling is introduced: a basic mode and an enhanced mode.

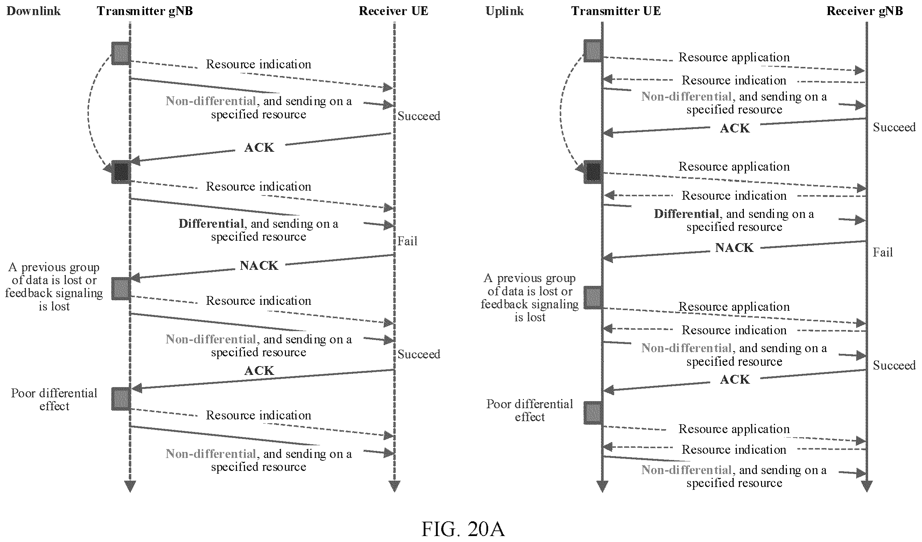

Basic mode: The transmitter determines, based on feedback for a previous group of data and a differential compression effect, whether to use a differential transmission manner. For example, if transmission of a previous group of data sent by the transmitter is lost or feedback signaling ACK/NACK for the previous group of data is lost, the transmitter can perform sending only in a non-differential transmission manner. Refer to FIG. 20A. FIG. 20A shows a feedback signaling design and interaction procedure in a basic mode. In other words, the transmitter successfully receives ACK signaling of the receiver for a previous group of data, and the transmitter uses the previous group of data as parameter data to perform transmission in a differential manner. The transmitter may add a 1-bit or multi-bit mode indication to a sent message, to indicate whether differential is currently used or not. In the basic mode, if differential is used, only the previous group of data is used as a reference.

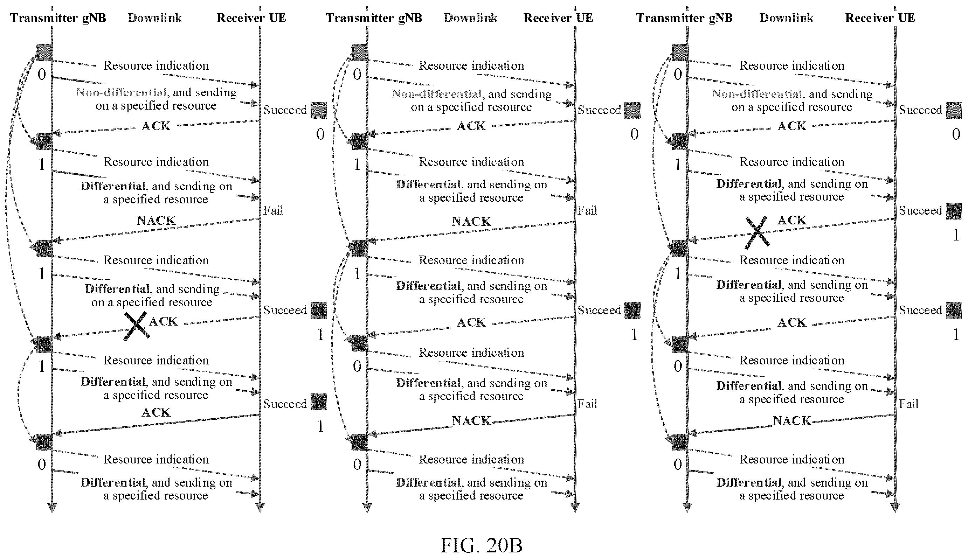

Compared with the basic mode, the enhanced mode is not limited to using only data sent last time as a reference, but allows the transmitter to use data successfully received by the receiver most recently (and an ACK fed back is also successfully received by the transmitter) as reference data of differential (as shown in FIG. 20B, a downlink is used as an example, and an uplink interaction procedure is similar). FIG. 20B shows a feedback signaling design and interaction procedure in an enhanced mode. In this case, one-bit ACK acknowledgment indication signaling needs to be added.

ACK acknowledgment signaling (denoted as an A indication): The signaling is carried each time data is sent, and indicates whether the transmitter successfully decodes ACK signaling that is fed back by the receiver most recently. Refer to FIG. 20B. When ACK signaling that is fed back by the receiver most recently is successfully received by the transmitter, a value of the ACK acknowledgment signaling is flipped. The receiver needs to select, based on the ACK acknowledgment signaling, a differential reference that is the same as that of the transmitter, that is, data that is successfully received by the receiver most recently from a perspective of the transmitter, to resist a feedback loss problem. As shown in FIG. 20B, the transmitter first sends data 1 to the receiver in a non-differential transmission manner, where a value of ACK acknowledgment indication signaling in the data 1 is 0. After successfully receiving an ACK for the data 1, the transmitter sends data 2 to the receiver in a differential transmission manner by using the data 1 as parameter data, where a value of ACK acknowledgment indication signaling in the data 2 is 1. The receiver determines, based on the ACK acknowledgment indication signaling in the data 2, that the data 1 is used as the parameter data for the data 2 sent by the transmitter.

The following describes, with reference to the accompanying drawings, structures of communication apparatuses (a transmitter and a receiver) that can implement embodiments of this application.

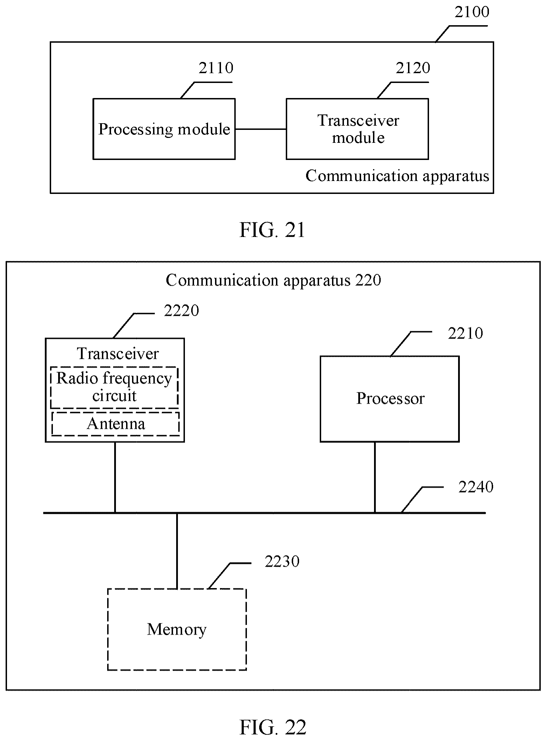

FIG. 21 is a diagram of a structure of a communication apparatus 2100 according to an embodiment of this application. The communication apparatus 2100 may correspondingly implement functions or steps implemented by the transmitter in the foregoing method embodiments, or may correspondingly implement functions or steps implemented by the receiver in the foregoing method embodiments. The communication apparatus may include a processing module 2110 and a transceiver module 2120. Optionally, a storage unit may be further included. The storage unit may be configured to store instructions (code or a program) and/or data. The processing module 2110 and the transceiver module 2120 may be coupled to the storage unit. For example, the processing module 2110 may read the instructions (the code or the program) and/or the data in the storage unit, to implement a corresponding method. The foregoing units may be independently disposed, or may be partially or all integrated. For example, the transceiver module 2120 may include a sending module and a receiving module. The sending module may be a transmitter, and the receiving module may be a receiver. An entity corresponding to the transceiver module 2120 may be a transceiver, or may be a communication interface.

In some possible implementations, the communication apparatus 2100 can correspondingly implement the behavior and the functions of the transmitter in the foregoing method embodiments. For example, the communication apparatus 2100 may be the transmitter, or may be a component (for example, a chip or a circuit) used in the transmitter. For example, the transceiver module 2120 may be configured to perform all receiving or sending operations performed by the transmitter in the embodiments in FIG. 6, FIG. 9, FIG. 10, FIG. 16, FIG. 17, and FIG. 19, and/or another process used to support the technology described in this specification. The processing module 2110 is configured to perform all operations performed by the transmitter other than the receiving and sending operations in the embodiments in FIG. 6, FIG. 9, FIG. 10, FIG. 16, FIG. 17, and FIG. 19 except the receiving and sending operations.

In some possible implementations, the communication apparatus 2100 can correspondingly implement the behavior and the functions of the receiver in the foregoing method embodiments. For example, the communication apparatus 2100 may be the receiver, or may be a component (for example, a chip or a circuit) used in the receiver. For example, the transceiver module 2120 may be configured to perform all receiving or sending operations performed by the receiver in the embodiments in FIG. 6, FIG. 16, FIG. 17, and FIG. 19, and/or another process used to support the technology described in this specification. For example, the processing module 2110 is configured to perform all operations performed by the receiver other than the receiving and sending operations in the embodiments in FIG. 6, FIG. 16, FIG. 17, and FIG. 19.

FIG. 22 is a diagram of a structure of another communication apparatus 220 according to an embodiment of this application. The communication apparatus in FIG. 22 may be the foregoing transmitter, or may be the foregoing receiver. As shown in FIG. 22, the communication apparatus 220 includes at least one processor 2210 and a transceiver 2220.

In some embodiments of this application, the processor 2210 and the transceiver 2220 may be configured to perform functions, operations, or the like performed by the transmitter. For example, the transceiver 2220 performs all receiving or sending operations performed by the transmitter in the embodiments in FIG. 6, FIG. 9, FIG. 10, FIG. 16, FIG. 17, and FIG. 19, and/or another process used to support the technology described in this specification. For example, the processor 2210 is configured to perform all operations performed by the transmitter other than the receiving and sending operations in the embodiments in FIG. 6, FIG. 9, FIG. 10, FIG. 16, FIG. 17, and FIG. 19.

In some embodiments of this application, the processor 2210 and the transceiver 2220 may be configured to perform functions, operations, or the like performed by the access end. For example, the transceiver 2220 performs all receiving or sending operations performed by the receiver in the embodiments in FIG. 6, FIG. 16, FIG. 17, and FIG. 19, and/or another process used to support the technology described in this specification. For example, the processor 2210 is configured to perform all operations performed by the receiver other than the receiving and sending operations in the embodiments in FIG. 6, FIG. 16, FIG. 17, and FIG. 19.

The transceiver 2220 is configured to communicate with another device/apparatus via a transmission medium. The processor 2210 receives and sends data and/or signaling via the transceiver 2220, and is configured to implement the methods in the foregoing method embodiments. The processor 2210 may implement functions of the processing module 2110, and the transceiver 2220 may implement functions of the transceiver module 2120.

Optionally, the transceiver 2220 may include a radio frequency circuit and an antenna. The radio frequency circuit is mainly configured to convert a baseband signal and a radio frequency signal, and process a radio frequency signal. The antenna is mainly configured to receive and send a radio frequency signal in a form of an electromagnetic wave. The input/output apparatus, such as a touchscreen, a display, and a keyboard, is mainly configured to: receive data input by a user and output data to the user.

Optionally, the communication apparatus 220 may further include at least one memory 2230, configured to store program instructions and/or data. The memory 2230 is coupled to the processor 2210. The coupling in this embodiment of this application may be an indirect coupling or a communication connection between apparatuses, units, or modules in an electrical form, a mechanical form, or another form, and is used for information exchange between the apparatuses, the units, or the modules. The processor 2210 may cooperate with the memory 2230. The processor 2210 may execute the program instructions stored in the memory 2230. At least one of the at least one memory may be included in the processor.

After the communication apparatus 220 is powered on, the processor 2210 may read the software program in the memory 2230, explain and execute instructions of the software program, and process data of the software program. When data needs to be sent in a wireless manner, after performing baseband processing on the to-be-sent data, the processor 2210 outputs a baseband signal to a radio frequency circuit. After performing radio frequency processing on the baseband signal, the radio frequency circuit sends a radio frequency signal through the antenna in an electromagnetic wave form. When data is sent to the communication apparatus, the radio frequency circuit receives a radio frequency signal through the antenna, converts the radio frequency signal into a baseband signal, and outputs the baseband signal to the processor 2210. The processor 2210 converts the baseband signal into data, and processes the data.

In another implementation, the radio frequency circuit and the antenna may be disposed independent of the processor that performs baseband processing. For example, in a distributed scenario, the radio frequency circuit and the antenna may be remotely disposed independent of the communication apparatus.

In this embodiment of this application, a specific connection medium between the transceiver 2220, the processor 2210, and the memory 2230 is not limited. In this embodiment of this application, the memory 2230, the processor 2210, and the transceiver 2220 are connected through a bus 2240 in FIG. 22. The bus is represented by using a thick line in FIG. 22. A connection manner between other components is merely an example for description, and is not limited thereto. The bus may be classified into an address bus, a data bus, a control bus, and the like. For ease of representation, only one bold line represents the bus in FIG. 22, but this does not mean that there is only one bus or only one type of bus.

In this embodiment of this application, the processor may be a general-purpose processor, a digital signal processor, an application-specific integrated circuit, a field programmable gate array or another programmable logic device, a discrete gate or a transistor logic device, or a discrete hardware component, and may implement or perform the methods, steps, and logical block diagrams disclosed in the embodiments of this application. The general-purpose processor may be a microprocessor, any conventional processor, or the like. The steps of the method disclosed with reference to embodiments of this application may be directly performed by a hardware processor, or may be performed by using a combination of hardware in the processor and a software module.

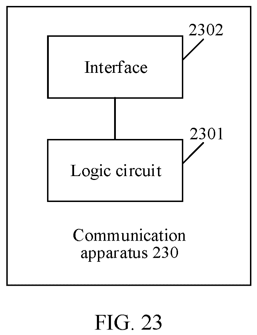

FIG. 23 is a diagram of a structure of another communication apparatus 230 according to an embodiment of this application. As shown in FIG. 23, the communication apparatus shown in FIG. 23 includes a logic circuit 2301 and an interface 2302. The processing module 2110 in FIG. 21 may be implemented as the logic circuit 2301, and the transceiver module 2120 in FIG. 21 may be implemented as the interface 2302. The logic circuit 2301 may be a chip, a processing circuit, an integrated circuit, a system on chip (system on chip, SoC) chip, or the like, and the interface 2302 may be a communication interface, an input/output interface, or the like. In this embodiment of this application, the logic circuit may further be coupled to the interface. A specific connection manner of the logical circuit and the interface is not limited in this embodiment of this application.

In some embodiments of this application, the logic circuit and the interface may be configured to perform functions, operations, or the like performed by the transmitter.

In some embodiments of this application, the logic circuit and the interface may be configured to perform functions, operations, or the like performed by the receiver.

This application further provides a computer-readable storage medium. The computer-readable storage medium stores a computer program or instructions. When the computer program or the instructions are run on a computer, the computer is enabled to perform the method in the foregoing embodiment.

This application further provides a computer program product. The computer program product includes instructions or a computer program. When the instructions or the computer program is run on a computer, the method in the foregoing embodiment is performed.

This application further provides a communication system, including the transmitter and the receiver.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the scope of protection of this application shall be subject to the scope of protection of the claims.

**Claims**

1. A data compression method, comprising:

   matching an element in a first group of data with an element in a second group of data, to obtain a first matching relationship, wherein the first group of data is data to be received by a receiver, and the second group of data is data that has been successfully received by the receiver; performing differencing on matched elements in the first group of data and the second group of data based on the first matching relationship, to obtain first differential data;

separately performing uniform quantization on data in each dimension in the first differential data, to obtain a first quantization result;

performing entropy encoding compression based on the first quantization result, to obtain compressed data; and

sending the compressed data to the receiver.

2. The method according to claim 1, wherein the matching the element in the first group of data with the element in the second group of data comprises:

performing differencing on the matched elements in the first group of data and the second group of data based on the first matching relationship, to obtain the first differential data, wherein the first matching relationship is an assumed matching relationship between an element in the first group of data and an element in the second group of data;

separately performing uniform quantization on the data in each dimension in the first differential data, to obtain the first quantization result;

determining a first code length of a codeword obtained by performing entropy encoding compression based on the first quantization result;

performing differencing on matched elements in the first group of data and the second group of data based on a second matching relationship, to obtain second differential data, wherein the second matching relationship is an assumed matching relationship between an element in the first group of data and an element in the second group of data, and the second matching relationship is different from the first matching relationship;

separately performing uniform quantization on data in each dimension in the second differential data, to obtain a second quantization result;

determining a second code length of a codeword obtained by performing entropy encoding compression based on the second quantization result; and

when the first code length is a shortest code length in multiple code lengths obtained by performing entropy encoding compression on the first group of data, using the first matching relationship as a matching relationship between an element in the first group of data and an element in the second group of data, wherein the multiple code lengths comprise the first code length and the second code length.

3. The method according to claim 1, wherein the matching the element in the first group of data with the element in the second group of data comprises:

performing differencing on the matched elements in the first group of data and the second group of data based on the first matching relationship, to obtain the first differential data, wherein the first matching relationship is an assumed matching relationship between an element in the first group of data and an element in the second group of data;

separately performing uniform quantization on the data in each dimension in the first differential data, to obtain the first quantization result;

separately transforming data in each dimension in the first quantization result into a nonnegative integer, to obtain a first transformation result;

determining a first code length of a codeword obtained by performing entropy encoding compression based on a first group of entropy encoding parameters and the first transformation result;

performing differencing on matched elements in the first group of data and the second group of data based on a second matching relationship, to obtain second differential data, wherein the second matching relationship is an assumed matching relationship between an element in the first group of data and an element in the second group of data, and the second matching relationship is different from the first matching relationship;

separately performing uniform quantization on data in each dimension in the second differential data, to obtain a second quantization result;

separately transforming data in each dimension in the second quantization result into a nonnegative integer, to obtain a second transformation result;

determining a second code length of a codeword obtained by performing entropy encoding compression based on a second group of entropy encoding parameters and the second transformation result, wherein the second group of entropy encoding parameters is the same as or different from the first group of entropy encoding parameters; and

when the first code length is a shortest code length in multiple code lengths obtained by performing entropy encoding compression on the first group of data, using the first matching relationship as a matching relationship between an element in the first group of data and an element in the second group of data, wherein the multiple code lengths comprise the first code length and the second code length; and

the performing entropy encoding compression based on the first quantization result, to obtain the compressed data comprises:

separately transforming the data in each dimension in the first quantization result into the nonnegative integer, to obtain the first transformation result; and

separately performing entropy encoding compression on data in a corresponding dimension in the first transformation result by using an entropy encoding parameter in each dimension in the first group of entropy encoding parameters, to obtain the compressed data, wherein the compressed data comprises first indication information, and the first indication information indicates the first group of entropy encoding parameters.

4. The method according to any one of claims 1 to 3, wherein when a quantity of elements in the first group of data is less than a quantity of elements in the second group of data, the compressed data comprises a first bitmap, one bit in the first bitmap corresponds to one element in the second group of data, and the first bitmap indicates whether an element in the second group of data is matched with an element in the first group of data.

5. The method according to claim 4, wherein an arrangement order of elements corresponding to bits in the first bitmap is the same as a compression encoding or decoding order of elements in the second group of data.

6. The method according to claim 4 or 5, wherein the compressed data further comprises second indication information, the second indication information indicates a quantity of third data groups, and the second group of data is obtained by combining two or more third data groups.

7. The method according to any one of claims 1 to 6, wherein an order of elements in the compressed data corresponds to a decoding order of elements in the second group of data at the receiver.

8. The method according to any one of claims 1 to 4, wherein after the matching the element in the first group of data with the element in the second group of data, to obtain the first matching relationship, the method further comprises:

when the quantity of elements in the first group of data is greater than the quantity of elements in the second group of data, matching a first part of elements with a second part of elements in the first group of data, to obtain a third matching relationship, wherein the first part of elements are an element that is in the first group of data and that is not matched with an element in the second group of data, and the second part of elements are an element that is in the first group of data and that is matched with an element in the second group of data;

performing differencing on matched elements in the first part of elements and the second part of elements based on the third matching relationship, to obtain third differential data; and

separately performing uniform quantization on data in each dimension in the third differential data, to obtain a third quantization result; and

the performing entropy encoding compression based on the first quantization result, to obtain the compressed data comprises:

performing entropy encoding compression based on the first quantization result and the third quantization result, to obtain the compressed data, wherein the compressed data comprises a second bitmap, one bit in the second bitmap corresponds to one element in the second part of elements, and the second bitmap indicates whether an element in the second part of elements is matched with an element in the first part of elements.

9. The method according to claim 8, wherein an arrangement order of elements corresponding to bits in the second bitmap is the same as a compression encoding or decoding order of elements in the second part of elements.

10. The method according to claim 8 or 9, wherein the compressed data comprises first compressed sub-data and second compressed sub-data, the first compressed sub-data corresponds to the first differential data, the second compressed sub-data corresponds to the third differential data, an order of elements in the first compressed sub-data corresponds to a decoding order of elements in the second group of data at the receiver, an order of elements in the second compressed sub-data corresponds to a decoding order of elements in a third part of elements at the receiver, and the third part of elements are an element that is in the second part of elements and that is matched with an element in the first part of elements.

11. The method according to claims 1 to 10, wherein the compressed data further comprises third indication information, and the third indication information indicates whether the compressed data is obtained in a differential manner.

12. The method according to claims 1 to 10, wherein the compressed data further comprises fourth indication information, and the fourth indication information indicates whether a transmitter successfully decodes acknowledgment ACK signaling that is most recently fed back by the receiver for data from the transmitter.

13. A data decompression method, comprising:

receiving compressed data from a transmitter;
decoding the compressed data, to obtain first differential data; and
adding each element in the first differential data and a reference element corresponding to each element, to obtain a first group of data, wherein each element in the first differential data corresponds to one element in a second group of data, a reference element corresponding to a first element in the first differential data is an element corresponding to the first element in the second group of data, the second group of data is data that has been successfully received by the receiver, and the first element is any element in the first differential data.

14. The method according to claim 13, wherein the compressed data comprises first indication information, and the first indication information indicates the first group of entropy encoding parameters; and the decoding the compressed data, to obtain the first differential data comprises:

determining the first group of entropy encoding parameters based on the first indication information; and
separately decoding data in a corresponding dimension in the compressed data by using an entropy encoding parameter in each dimension in the first group of entropy encoding parameters, to obtain the first differential data.

15. The method according to claim 13 or 14, wherein the compressed data comprises a first bitmap, one bit in the first bitmap corresponds to one element in the second group of data, and the first bitmap indicates whether an element in the second group of data is matched with an element in the first group of data; and the method further comprises:
determining, based on the first bitmap, the reference element corresponding to each element in the first differential data.

16. The method according to claim 15, wherein an arrangement order of elements corresponding to bits in the first bitmap is the same as a compression encoding or decoding order of elements in the second group of data.

17. The method according to claim 15 or 16, wherein the compressed data further comprises second indication information, the second indication information indicates a quantity of third data groups, and the second group of data is obtained by combining two or more third data groups.

18. The method according to any one of claims 13 to 17, wherein an order of elements in the compressed data corresponds to a decoding order of elements in the second group of data at the receiver.

19. The method according to claim 13, wherein the decoding the compressed data, to obtain the first differential data comprises:

decoding the compressed data, to obtain the first differential data and third differential data, wherein the compressed data comprises a second bitmap, one bit in the second bitmap corresponds to one element in the first differential data, and the second bitmap indicates whether an element in the first differential data is matched with an element in the third differential data; and
the adding each element in the first differential data and the reference element corresponding to each element, to obtain the first group of data comprises:
adding each element in the first differential data and the reference element corresponding to each element, and adding each element in the third differential data and a reference element corresponding to each element, to obtain the first group of data, wherein a reference element corresponding to a second element in the third differential data is a sum of a third element corresponding to the second element in the first differential data and a reference element corresponding to the third element, and the second element is any element in the third differential data.

20. The method according to claim 19, wherein an arrangement order of elements corresponding to bits in the second bitmap is the same as a compression encoding or decoding order of elements in the first differential data.

21. The method according to claim 19 or 20, wherein an order of elements in the first differential data corresponds to a decoding order of elements in the second group of data at the receiver, and an order of elements in the third differential data corresponds to a decoding order, at the receiver, of elements that are in the first differential data and that are associated with the third differential data.

22. The method according to any one of claims 13 to 21, wherein the compressed data further comprises third indication information, and the third indication information indicates whether the compressed data is obtained in a differential manner.

**23.** The method according to any one of claims 13 to 21, wherein the compressed data further comprises fourth indication information, and the fourth indication information indicates whether the transmitter successfully decodes acknowledgment ACK signaling that is most recently fed back by the receiver for data from the transmitter.

**24.** A communication apparatus, comprising a module or a unit configured to implement the method according to any one of claims 1 to 12.

**25.** A communication apparatus, comprising a module or a unit configured to implement the method according to any one of claims 13 to 23.

**26.** A communication system, wherein the communication system comprises the communication apparatus according to claim 24 and the communication apparatus according to claim 25.

**27.** A computer-readable storage medium, wherein the computer-readable storage medium stores a computer program, the computer program comprises program instructions, and when the program instructions are executed, a computer is enabled to perform the method according to any one of claims 1 to 23.

**28.** A communication apparatus, comprising a processor, wherein the processor is coupled to a memory, the memory stores computer program instructions, and the processor is configured to execute the computer program instructions, so that the communication apparatus performs the method according to any one of claims 1 to 23.

**29.** A computer program product, wherein the computer program product comprises a computer program, the computer program comprises program instructions, and when the program instructions are executed, a computer is enabled to perform the method according to any one of claims 1 to 23.

FIG. 1

FIG. 2

FIG. 3

FIG. 4

FIG. 5

EP 4 672 753 A1

Transmitter                                              Receiver

601

The transmitter matches an element in a first group
of data with an element in a second group of data, to
obtain a first matching relationship

602

Perform differencing on matched elements in the
first group of data and the second group of data
based on the first matching relationship, to obtain
first differential data

603

Separately perform uniform quantization on data in
each dimension in the first differential data, to
obtain a first quantization result

604

The transmitter performs entropy encoding
compression based on the first quantization result, to
obtain compressed data

Compressed data          605

606

The receiver decodes the compressed data, to obtain
the first differential data

607

The receiver adds each element in the first
differential data and a reference element
corresponding to each element, to obtain the first
group of data

FIG. 6

First group of data (at a current moment)

Second group of data (at a previous moment)

FIG. 7

$y_j$

$d_2$

$CodeLen_2 = f(d_2, k_2)$

$x_i$

$d_1$

$CodeLen_1 = f(d_1, k_1)$

FIG. 8

A transmitter performs differencing on matched elements in a first group of data and a second group of data based on a first matching relationship, to obtain first differential data — 901

Separately perform uniform quantization on data in each dimension in the first differential data, to obtain a first quantization result — 902

Determine a first code length of a codeword obtained by performing entropy encoding compression based on the first quantization result — 903

Perform differencing on matched elements in the first group of data and the second group of data based on a second matching relationship, to obtain second differential data — 904

Separately perform uniform quantization on data in each dimension in the second differential data, to obtain a second quantization result — 905

Determine a second code length of a codeword obtained by performing entropy encoding compression based on the second quantization result — 906

When the first code length is a shortest code length in multiple code lengths obtained by performing entropy encoding compression on the first group of data, use the first matching relationship as a matching relationship between an element in the first group of data and an element in the second group of data — 907

FIG. 9

1001

A transmitter performs differencing on matched elements in a first group of data and a second group of data based on a first matching relationship, to obtain first differential data

1002

Separately perform uniform quantization on data in each dimension in the first differential data, to obtain a first quantization result

1003

Separately transform data in each dimension in the first quantization result into a nonnegative integer, to obtain the first transformation result

1004

Determine a first code length of a codeword obtained by performing entropy encoding compression based on a first group of entropy encoding parameters and the first transformation result

1005

The transmitter performs differencing on matched elements in the first group of data and the second group of data based on a second matching relationship, to obtain second differential data

1006

Separately perform uniform quantization on data in each dimension in the second differential data, to obtain a second quantization result

1007

Separately transform data in each dimension in the second quantization result into a nonnegative integer, to obtain a second transformation result

1008

Determine a second code length of a codeword obtained by performing entropy encoding compression based on a second group of entropy encoding parameters and the second transformation result

1009

When the first code length is a shortest code length in multiple code lengths obtained by performing entropy encoding compression on the first group of data, use the first matching relationship as a matching relationship between an element in the first group of data and an element in the second group of data

FIG. 10

Dynamic indication and sending                    Configured via higher-layer signaling

Entropy encoding
parameter $k_1$          Dimension 1                    $e_1$              $K_1$

Entropy encoding
parameter $k_2$          Dimension 2                    $e_2$              $K_2$

                         Differential entropy-encoded    Quantization error accuracy in
            ...          (Golomb-encoded) data           each dimension              ...

Entropy encoding
parameter $k_D$          Dimension D                    $e_D$              $K_D$

                                                        Entropy encoding (Golomb)
                                                        parameter set

✓ Green indicates a fixed length, and yellow indicates a variable length

✓ **An order of entropy-encoded (Golomb-encoded) data is consistent with a decoding order of a second group of data at a receiver**

FIG. 11

FIG. 12

**A first bitmap indicates**: A length of a bit string is equal to a quantity of **elements (■) in a second group of data**, each bit corresponds to **one element (■) in the second group of data**, and an arrangement order is **a compression/decompression order of elements (■) in the second group of data at a previous current, where 1 indicates match, and 2 indicates no match**.

11100111

Entropy encoding parameter $k_1$ | Dimension 1

Entropy encoding parameter $k_2$ | Dimension 2

...

Entropy encoding parameter $k_D$ | Dimension D

Entropy-encoded (Golomb-encoded) data

An order used when entropy encoding (Golomb encoding) is performed on differential values is consistent with the compression/decompression order of elements (■) in the second group of data at the previous moment

FIG. 13

FIG. 14

**A second bitmap indicates:** A length of a bit string is equal to **elements (○ and ●) in a first group of data that have been matched with elements in a second group of data,** each bit corresponds to one (○ and ●), and an arrangement order is **a compression/decompression order, at a current moment, of the elements (○ and ●) in the first group of data that have been matched with the elements in the second group of data,** where 0 corresponds to (○), and 1 corresponds to (●).

Entropy encoding parameter $k_1$

Dimension 1

Entropy encoding parameter $k_2$

Dimension 2

...

Entropy encoding parameter $k_D$

Dimension D

**Entropy-encoded (Golomb-encoded) data includes a differential between elements in the second group**

1    2

1: An order is consistent with a decoding order of elements (■) in the second group of data at a receiver
2: An order is consistent with selected elements (●) in the first group of data that have been matched with the second group of data

FIG. 15

Transmitter

Receiver

1601

The transmitter determines a first matching relationship and a first group of entropy encoding parameters based on a first group of data and a second group of data

1602

Perform differencing on matched elements in the first group of data and the second group of data based on the first matching relationship, to obtain first differential data

1603

Separately perform uniform quantization on data in each dimension in the first differential data, to obtain a first quantization result

1604

Transform the first quantization result into a nonnegative integer, to obtain a first transformation result

1605

Separately perform entropy encoding compression on data in a corresponding dimension in the first transformation result by using an entropy encoding parameter in each dimension in the first group of entropy encoding parameters, to obtain compressed data

Compressed data 1606

1607

The receiver obtains the first group of entropy encoding parameters based on first indication information in the compressed data

1608

Decode entropy-encoded data in the compressed data based on the entropy encoding parameter in each dimension in the first group of entropy encoding parameters, to obtain the first differential data

1609

The receiver adds each element in the first differential data and a reference element corresponding to each element, to obtain the first group of data

FIG. 16

```
      ┌──────────────┐                              ┌────────────┐
      │ Transmitter  │                              │  Receiver  │
      └──────────────┘                              └────────────┘
```

                                                                    1701

The transmitter combines two groups of data used as a reference into a second group of data

                                                                    1702

The transmitter determines a first matching relationship and a first group of entropy encoding parameters based on a first group of data and the second group of data

                                                                    1703

Perform differencing on matched elements in the first group of data and the second group of data based on the first matching relationship, to obtain first differential data

                                                                    1704

Separately perform uniform quantization on data in each dimension in the first differential data, to obtain a first quantization result

                                                                    1705

Transform the first quantization result into a nonnegative integer, to obtain a first transformation result

                                                                    1706

Separately perform entropy encoding compression on data in a corresponding dimension in the first transformation result by using an entropy encoding parameter in each dimension in the first group of entropy encoding parameters, to obtain compressed data

                                    Compressed data         1707
                                    ──────────────────────────▶

                                                                    1708

The receiver obtains the first group of entropy encoding parameters based on first indication information in the compressed data

                                                                    1709

Decode entropy-encoded data in the compressed data based on the entropy encoding parameter in each dimension in the first group of entropy encoding parameters, to obtain the first differential data

                                                                    1710

Obtain the second group of data based on second indication information in the compressed data

                                                                    1711

The receiver adds each element in the first differential data and a reference element corresponding to each element, to obtain the first group of data

FIG. 17

01

1010001010101

First bitmap: A length of a bit string is equal to a quantity of elements in a second group of data, each bit corresponds to one element in the second group of data, and an arrangement order of elements corresponding to bits in the first bitmap is the same as a decoding order of elements in the second group of data at a receiver

Entropy encoding parameter $k_1$

Dimension 1

Entropy encoding parameter $k_2$

Dimension 2

...

Entropy encoding parameter $k_D$

Dimension D

Entropy-encoded (Golomb-encoded) data

An order used when entropy compression encoding is performed on differential values in differential data is consistent with the decoding order of elements in the second group of data at the receiver

FIG. 18

EP 4 672 753 A1

EP 4 672 753 A1

| Transmitter | | Receiver |

1901

The transmitter matches an element in a first group of data with an element in a second group of data, to obtain a first matching relationship

1902

When a quantity of elements in the first group of data is greater than a quantity of elements in the second group of data, match a first part of elements with a second part of elements in the first group of data, to obtain a third matching relationship

1903

Perform differencing on matched elements in the first group of data and the second group of data based on the first matching relationship, to obtain first differential data

1904

Separately perform uniform quantization on data in each dimension in the first differential data, to obtain a first quantization result

1905

Separately transform data in each dimension in the first quantization result into a nonnegative integer, to obtain a first transformation result

1906

Perform differencing on matched elements in the first part of elements and the second part of elements based on the third matching relationship, to obtain third differential data

1907

Separately perform uniform quantization on data in each dimension in the third differential data, to obtain a third quantization result

1908

Separately transform data in each dimension in the third quantization result into a nonnegative integer, to obtain a third transformation result

1909

Perform entropy encoding compression on the first transformation result and the third transformation result, to obtain compressed data

Compressed data    1910

1911

The receiver obtains a first group of entropy encoding parameters based on first indication information in the compressed data

1912

Decode entropy-encoded data in the compressed data based on an entropy encoding parameter in each dimension in the first group of entropy encoding parameters, to obtain the first differential data and the third differential data

1913

Add each element in the first differential data and a reference element corresponding to each element, and add each element in the third differential data and a reference element corresponding to each element, to obtain the first group of data

FIG. 19

Downlink    Transmitter gNB                                    Receiver UE        Uplink        Transmitter UE                                    Receiver gNB

Resource indication

Non-differential, and sending on a
specified resource

Succeed

ACK

Resource indication

Differential, and sending on a
specified resource

Fail

A previous group
of data is lost or
feedback signaling
is lost

NACK

Resource indication

Non-differential, and sending on a
specified resource

Succeed

ACK

Poor differential
effect

Resource indication

Non-differential, and sending on a
specified resource

Resource application

Resource indication

Non-differential, and sending on a
specified resource

ACK

Succeed

Resource application

Resource indication

Differential, and sending on a
specified resource

NACK

Fail

A previous group
of data is lost or
feedback signaling
is lost

Resource application

Resource indication

Non-differential, and sending on a
specified resource

ACK

Succeed

Poor differential
effect

Resource application

Resource indication

Non-differential, and sending on a
specified resource

FIG. 20A

FIG. 20B

2100

Communication apparatus

2110

Processing module

2120

Transceiver module

FIG. 21

Communication apparatus 220

2220

Transceiver

Radio frequency circuit

Antenna

2210

Processor

2240

2230

Memory

FIG. 22

2302

Interface

2301

Logic circuit

Communication
apparatus 230

FIG. 23

## INTERNATIONAL SEARCH REPORT

| International application No. |
| --- |
| **PCT/CN2023/089028** |

**A. CLASSIFICATION OF SUBJECT MATTER**

H04N19/597(2014.01)i

According to International Patent Classification (IPC) or to both national classification and IPC

**B. FIELDS SEARCHED**

Minimum documentation searched (classification system followed by classification symbols)

IPC:H04N

Documentation searched other than minimum documentation to the extent that such documents are included in the fields searched

Electronic data base consulted during the international search (name of data base and, where practicable, search terms used)

CNKI, CNABS, CNTXT, VEN, USTXT, EPTXT, WOTXT: 差分, 量化, 匹配, 熵, 压缩, 接收, 解压缩, 维度, 码长, 码字, 变换, 参数, 指示, 位图, differential, quantification, match, entropy, compression, receive, decompression, dimension, codeword, code, length, transformation, parameters, indication, bitmap

**C. DOCUMENTS CONSIDERED TO BE RELEVANT**

| Category* | Citation of document, with indication, where appropriate, of the relevant passages | Relevant to claim No. |
| --- | --- | --- |
| X | US 2021099732 A1 (QUALCOMM INC.) 01 April 2021 (2021-04-01)<br>description, paragraphs 17-162, and figures 1-7 | 1, 4-7, 11-18, 22-29 |
| A | US 2012082395 A1 (ABDO NADIM Y et al.) 05 April 2012 (2012-04-05)<br>entire document | 1-29 |
| A | US 2018136308 A1 (HERE GLOBAL B.V.) 17 May 2018 (2018-05-17)<br>entire document | 1-29 |
| A | US 2020175725 A1 (POINT CLOUD COMPRESSION B.V.) 04 June 2020 (2020-06-04)<br>entire document | 1-29 |
| A | US 2022353538 A1 (BEIJING DAJIA INTERNET INFORMATION TECHNOLOGY CO., LTD.) 03 November 2022 (2022-11-03)<br>entire document | 1-29 |
| A | WO 2022117036 A1 (HUAWEI TECHNOLOGIES CO., LTD.) 09 June 2022 (2022-06-09)<br>entire document | 1-29 |

☑ Further documents are listed in the continuation of Box C.    ☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **18 December 2023** | **02 January 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/089028** |

**C.     DOCUMENTS CONSIDERED TO BE RELEVANT**

| Category* | Citation of document, with indication, where appropriate, of the relevant passages | Relevant to claim No. |
| --- | --- | --- |
| A | WO 2022166462 A1 (HUAWEI TECHNOLOGIES CO., LTD.) 11 August 2022 (2022-08-11) entire document | 1-29 |

Form PCT/ISA/210 (second sheet) (July 2022)

## INTERNATIONAL SEARCH REPORT
### Information on patent family members

| International application No. |
| --- |
| **PCT/CN2023/089028** |

| Patent document cited in search report | | | | Publication date (day/month/year) | Patent family member(s) | | | Publication date (day/month/year) |
| --- | --- | --- | --- | --- | --- | --- | --- | --- |
| US | 2021099732 | A1 | | 01 April 2021 | TW | 202127887 | A | 16 July 2021 |
| | | | | | KR | 20220062539 | A | 17 May 2022 |
| | | | | | US | 11310533 | B2 | 19 April 2022 |
| | | | | | WO | 2021062225 | A1 | 01 April 2021 |
| | | | | | EP | 4035378 | A1 | 03 August 2022 |
| US | 2012082395 | A1 | | 05 April 2012 | BR | 112013007612 | A2 | 24 September 2019 |
| | | | | | MX | 2013003615 | A | 09 May 2013 |
| | | | | | RU | 2013114349 | A | 10 October 2014 |
| | | | | | KR | 20140006778 | A | 16 January 2014 |
| | | | | | WO | 2012050722 | A2 | 19 April 2012 |
| | | | | | WO | 2012050722 | A3 | 19 July 2012 |
| | | | | | CA | 2812740 | A1 | 19 April 2012 |
| | | | | | EP | 2622507 | A2 | 07 August 2013 |
| | | | | | EP | 2622507 | A4 | 26 August 2015 |
| | | | | | JP | 2013541295 | A | 07 November 2013 |
| | | | | | AU | 2011314228 | A1 | 28 March 2013 |
| | | | | | AU | 2011314228 | B2 | 31 July 2014 |
| US | 2018136308 | A1 | | 17 May 2018 | WO | 2016180480 | A1 | 17 November 2016 |
| | | | | | EP | 3751304 | A1 | 16 December 2020 |
| | | | | | US | 10520579 | B2 | 31 December 2019 |
| | | | | | US | 2020116818 | A1 | 16 April 2020 |
| | | | | | US | 11221390 | B2 | 11 January 2022 |
| | | | | | EP | 3295206 | A1 | 21 March 2018 |
| | | | | | EP | 3295206 | B1 | 29 July 2020 |
| | | | | | US | 2022128646 | A1 | 28 April 2022 |
| US | 2020175725 | A1 | | 04 June 2020 | US | 10762667 | B2 | 01 September 2020 |
| US | 2022353538 | A1 | | 03 November 2022 | EP | 4042702 | A1 | 17 August 2022 |
| | | | | | EP | 4042702 | A4 | 19 July 2023 |
| | | | | | WO | 2021067278 | A1 | 08 April 2021 |
| | | | | | JP | 2022541679 | A | 26 September 2022 |
| | | | | | JP | 7389898 | B2 | 30 November 2023 |
| | | | | | KR | 20220065883 | A | 20 May 2022 |
| | | | | | MX | 2022004026 | A | 02 May 2022 |
| WO | 2022117036 | A1 | | 09 June 2022 | EP | 4246971 | A1 | 20 September 2023 |
| WO | 2022166462 | A1 | | 11 August 2022 | | None | | |

Form PCT/ISA/210 (patent family annex) (July 2022)